# EUROPÄISCHE PATENTSCHRIFT

(11) **EP 1 685 569 B1**
(45) Veröffentlichungstag und Bekanntmachung des Hinweises auf die Patenterteilung: **17.03.2010**
(21) Anmeldenummer: 04790634.2
(22) Anmeldetag: 19.10.2004
(51) Int. Cl.: G11C 11/34, H01L 45/00

(54) **PHASENWECHSELSPEICHER, PHASENWECHSELSPEICHERANORDNUNG, PHASENWECHSELSPEICHERZELLE, 2D-PHASENWECHSELSPEICHERZELLEN-ARRAY, 3D-PHASENWECHSELSPEICHERZELLEN-ARRAY UND ELEKTRONIKBAUSTEIN**
PHASE CHANGE MEMORY, PHASE CHANGE MEMORY ASSEMBLY, PHASE CHANGE MEMORY CELL, 2D PHASE CHANGE MEMORY CELL ARRAY, 3D PHASE CHANGE MEMORY CELL ARRAY AND ELECTRONIC COMPONENT
MEMOIRE A CHANGEMENT DE PHASE, ENSEMBLE DE MEMOIRES A CHANGEMENT DE PHASE, CELLULE DE MEMOIRE A CHANGEMENT DE PHASE, RESEAU DE CELLULES DE MEMOIRE A CHANGEMENT DE PHASE 2D, RESEAU DE CELLULES DE MEMOIRE A CHANGEMENT DE PHASE 3D ET COMPOSANT ELECTRONIQUE

(30) Priorität: 23.10.2003 DE 10349750
(43) Veröffentlichungstag der Anmeldung: 02.08.2006
(73) Patentinhaber: Rheinisch-Westfälische Technische Hochschule Aachen (RWTH), 52062 Aachen (DE); COMMISSARIAT A L'ENERGIE ATOMIQUE, 75015 Paris (FR)
(72) Erfinder: HARING-BOLIVAR, Peter, 57482 Wenden (DE); BECHEVET, Bernard, F-38640 Claix (FR); SOUSA, Veronique, F-38000 Grenoble (FR); KIM, Dae-Hwang, 52074 Aachen (DE); KURZ, Heinrich, 52076 Aachen (DE); MERGET, Florian, 52062 Aachen (DE)
(74) Vertreter: Nüsse, Stephan
(86) Internationale Anmeldenummer: PCT/EP2004/011812
(87) Internationale Veröffentlichungsnummer: WO 2005/041196

(56) Entgegenhaltungen:
- EP-A1- 1 318 552
- WO-A-2004/057618
- TYSON S ET AL: "Nonvolatile, high density, high performance phase-change memory" IEEE 2000, Bd. 5, 18. März 2000 (2000-03-18), Seiten 385-390, XP010517190 in der Anmeldung erwähnt

## Beschreibung

Die Erfindung betrifft einen Phasenwechselspeicher mit einer Speichermaterialschicht eines Phasenwechselmaterials und einem ersten und zweiten elektrischen Kontakt, die voneinander beabstandet sind und über die ein Schaltbereich der Speichermaterialschicht von einem Stromsignal durchsetzbar ist, wobei mittels dem Stromsignal ein reversibler Phasenwechsel zwischen einer kristallinen Phase und einer amorphen Phase und damit eine Widerstandsänderung des Phasenwechselmaterials in den Schaltbereich induzierbar ist.
Die Erfindung führt auch auf eine Phasenwechselspeicheranordnung, eine Phasenwechselspeicherzelle, ein 2D-Phasenwechselspeicherzelle-Array, ein 3D-Phasenwechselspeicherzellen-Array und einen Elektronikbaustein.

Eines der wesentlichen Fundamente moderner Informationstechnologien sind nicht-flüchtige Speicher. In allen Datenverarbeitungs-, Datenübertragungs- und "Consumer-Electronics"-Geräten (Digitalkameras, Videokameras, Mobiltelefone, Computer etc.) werden nicht-flüchtige Speicher benötigt, um Informationen zwischenzuspeichern, oder um beim Einschalten eines Geräts wichtige Informationen für Bootvorgänge bereit zu halten. Der derzeitige Hauptvertreter für elektronische nicht-flüchtige Speicher ist das sogenannte FLASH-Memory. Zukünftige nicht-flüchtige Speicher könnten durch magnetische Speicher (MRAM) oder ferrorelektrische Speicher (FRAM)oder insbesondere Phasenwechselspeicher (Phase-Change RAM / PC-RAM / PRAM / Ovonic-Unified-Memory - OUM) bereitgestellt werden.

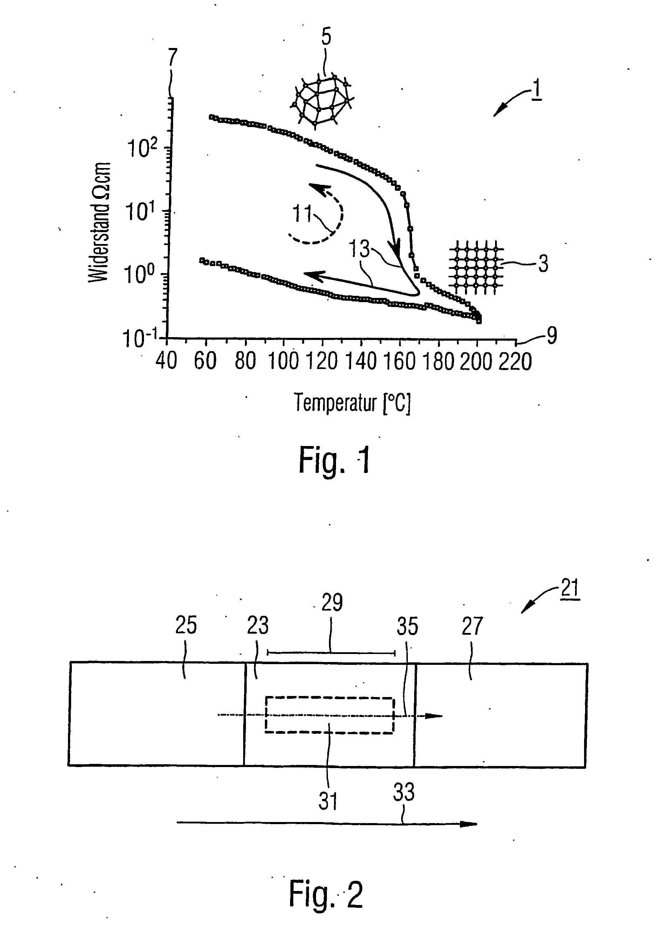

Letztere sind Gegenstand dieser Anmeldung. Phasenwechselspeicher weisen eine Speichermaterialschicht eines Phasenwechselmaterials auf und einen ersten und zweiten elektrischen Kontakt, die von einander beabstandet sind. Über die elektrischen Kontakte ist ein Schaltbereich der Speichermaterialschicht von einem beispielsweise einen gepulsten Schaltstrom führenden Stromsignal durchsetzbar. Mittels dem Stromsignal ist ein reversibler Phasenwechsel zwischen einer kristallinen Phase und einer amorphen Phase und damit eine Widerstandsänderung des Phasenwechselmaterials im Schaltbereich thermisch induzierbar. Bei einem dynamischen Bereich der Widerstandsänderung von bis zu drei Größenordnungen wird dies zur Bit- oder Multi-Bit-Informationspeicherung in einem Phasenwechselspeicher genutzt. Das physikalische Prinzip eines Phasenwechselspeichers wird im Rahmen der Fig. 1 der detailierten Beschreibung genauer erläutert.

Phasenwechselspeicher sind im Prinzip bereits seit den sechziger Jahren bekannt und beispielsweise in dem Artikel "Reversibel Electrical Switching Phenomena in Disordered Structures" von Ovshinsky in Physical Review Letters, Vol.21, Seite 1450-1453, beschrieben. Der Stand der aktuellen Technologie ist den Artikeln "OUM - A 180nm Nonvolatile Memory Cell Element Technology for Stand Alone and Embedded Applications" von Lai und Lowrey in IEEE 2001, Seiten 36.5.1 bis 36.5.4 und "Nonvolatile, High Density, High Performance Phase-Change Memory" von Tyson, Wicker, Lowrey, Hudgens und Hunt in IEEE 2000, Seiten 385 bis 390, zu entnehmen.

Die heutige Informations-Technologie lässt eine Konvergenz der Bereiche der kostengünstigen Massenspeicher (z. B. Festplatten und optische Datenspeicher) und schneller elektrischer Speicher (z.B. FLASH) zu sogenannten "Unified Memories" (PC-RAM) erwarten, die eine kostengünstige Herstellung und eine schnelle Random-Adressierung vereinen, um mit einer einzigen Technologie beide Marktsegmente zu bedienen. Die Durchsetzungsfähigkeit und das Potenzial von Phasenwechselspeichern als nicht-flüchtige Speicher in diesem Szenario hängt entscheidend davon ab, in welchem Maße sich eine Vielzahl von Phasenwechselspeichern hochintegrieren lässt.
Dazu muss ein Phasenwechselspeicher mit möglichst kleinen Schaltströmen eines Stromsignals schaltbar sein, da ein Phasenwechselspeicher sonst mit zukünftigen hochintegrierten CMOS-Steuertransistoren nicht betrieben werden kann.

Das gegenwärtige Konzept eines Phasenwechselspeichers ist in der US Patentanmeldung US 5,933,365 im Detail beschrieben. Dieses Konzept basiert auf einem vertikalen Stromfluss zwischen zwei übereinander angeordneten elektrischen Kontakten des Phasenwechselspeichers. D. h. der Strom eines Stromsignals zum Schalten eines Phasenwechselspeichers der eingangs genannten Art wird senkrecht zur lateralen Ausdehnung des Phasenwechselspeichers, also senkrecht zur Depositions/Lithographieebene des Phasenwechselspeichers zwischen zwei in der vertikalen Ausdehnung übereinander liegenden elektrischen Schichtkontakten geführt. Dieser "vertikale" Aufbau für einen Phasenwechselspeicher ist nach üblicher Anschauung der zu bevorzugende, um in einem Phasenwechselspeicher-Array möglichst viele Zellen über eine Zeilen/Spalten-(X/Y)-Adressierung integrieren zu können. Ein Beispiel eines dreidimensionalen (3D)-Phasenwechselspeicher-Arrays ist in der US 6,525,953 B1 beschrieben.

Problematisch ist, dass der Phasenwechsel zwischen einer kristallinen Phase und einer amorphen Phase im Phasenwechselmaterial über einen Strompuls des Stromsignals thermisch, z.B. unter Ausnutzung eines Temperaturbereichs zwischen Raumtemperatur und 600°C, induziert wird. Das Stromsignal wird dabei über die elektrischen, in der Regel metallischen, Kontakte dem Phasenwechselspeicher derart zugeführt, dass ein Schaltbereich einer Speichermaterialschicht von dem Stromsignal durchsetzt wird. Da elektrische Leiter in der Regel auch gute thermische Leiter sind bedeutet dies bei den bisher üblichen Konzepten eines Phasenwechselspeichers, dass vom thermisch beeinflussten Schaltbereich zum elektrischen Kontakt hin ein hoher Energieabfluss auftritt, was wiederum eine Steigerung der Schaltströme des Stromsignals erforderlich macht.

Kleine Steuertransistoren, die jedes hochintegrierbare Speicherelement braucht, liefern in der Regel allerdings nicht genügend Strom zum Schalten eines üblichen Phasenwechselspeichers gemäß dem vertikalen Aufbau. Die in der US 5,933,365 favorisierte Lösung besteht deshalb in der Nutzung eines sogenannten "Heaters" d. h. es wird im Rahmen des vertikalen Aufbaus jeweils zwischen einem elektrischen Kontakt und der Speichermaterialschicht eine "Heater"-Schicht angebracht, welche aus einem Material besteht, die Strom und Wärme schlechter leitet, als der elektrische Kontakt selbst. Der "Heater" hat also eine thermisch isolierende Wirkung zwischen Speichermaterialschicht und elektrischem Kontakt. Auf diese Weise lässt sich der Schaltbereich des Phasenwechselspeichers effizienter aufheizen und im Ergebnis mit niedrigeren Schaltströmen schalten. Das heißt es lässt sich ein Phasenwechsel zwischen einer kristallinen Phase und einer amorphen Phase und damit eine Widerstandsänderung des Phasenwechselmaterials im Schaltbereich mit geringeren Schaltströmen eines Stromsignals induzieren.

Der Effekt der in der US 5,933,365 vorgesehenen "Heater"-Schicht im Rahmen des vertikalen Aufbaus des Phasenwechselspeichers ist jedoch begrenzt und verringert den Schaltstrombedarf für ein Stromsignal nicht ausreichend, um eine ausreichend hohe Integrierbarkeit zu erreichen. Darüber hinaus wird durch die "Heater"-Schichten der Aufbau eines Phasenwechselspeichers zunehmend komplizierter.

EP 1 318 552 A1 offenbart einen weiteren Phasenwechselspeicher basierend auf einem vertikalen Stromfluss zwischen zwei übereinander angeordneten elektrischen Kontakten des Phasenwechselspeichers. Letzterer wird gebildet in Form einer Kontaktstruktur in einem elektronischen Halbleiterbauelement, umfassend einen ersten leitfähigen Bereich aufweisend einen ersten dünnen Teil mit einer ersten Sublithographie-Abmessung in einer ersten Richtung; einem zweiten leitfähigen Bereich aufweisend einen zweiten dünnen Teil mit einer zweiten Sublithographie-Abmessung in einer zweiten Richtung, quer zur ersten Richtung; wobei der erste und zweite leitfähige Bereich in direktem elektronischen Kontakt mit dem ersten und zweiten dünnen Teil ist, die ein Kontaktgebiet mit sublithographischer Ausdehnung definieren. Die dünnen sublithographischen Teile werden durch Verwendung von Deposition statt Lithographie erhalten. Die Abmessungen des Kontaktgebiets werden durch die Dicke der Depositionsschichten bestimmt. Das Volumen eines dünnen chalkogeniden Teils oberhalb des Kontaktgebiets formt den Phasenwechselbereich.

WO 2004/057618 A2 hat einen Zeitrang, der vor dem Zeitrang der vorliegenden Anmeldung liegt und ist nach dem Zeitrang der vorliegenden Anmeldung veröffentlicht nur in Bezug auf die Neuheit der vorliegenden Anmeldung relevant. WO 2004/057618 A2 offenbart einen elektrischen Baustein mit einem Körper, der einen Widerstand aufweist, der ein Phasenwechselspeichermaterial, das zwischen einer ersten Phase und einer zweiten Phase änderbar ist, hat. Aufgrund anisotropen Ätzens einer leitenden Schicht und anisotropen Ätzens einer Phasenwechselspeichermaterialschicht kontaktiert die leitende Sicht einen Seitenwand-Abstandhalter der Phasenwechselspeichermaterialschicht nicht direkt, sonder in einem Abstand. Die Stromdichte im Seitenwand-Abstandhalter ist höher als an einem ersten und zweiten Kontaktbereich, so dass das Phasenwechsetspeichermaterial am Seitenwand-Abstandhalter einen Phasenübergang durchläuft eher als ein Phasenwechselspeichermaterial am ersen und zweiten Kontaktbereich.

Aufgabe der vorliegenden Erfindung ist es, einen Phasenwechselspeicher und darauf aufbauende Bauelemente anzugeben, wobei der Schaltstrom eines Stromsignals und der Wärmeabfluss über die elektrischen Kontakte des Phasenwechselspeichers möglichst gering gehalten ist und gleichzeitig der strukturelle Aufbau eines Phasenwechselspeichers möglichst einfach bleiben soll.

Diese Aufgabe wird durch die Erfindung gemäß Anspruch 1 mittels eines eingangs genannten Phasenwechselspeichers gelöst, bei dem erfindungsgemäß der Schaftbereich entlang einer lateralen Ausdehnung des Phasenwechselspeichers zwischen dem ersten und zweiten elektrischen Kontakt angeordnet ist, wobei eine Stromführung des Stromsignals durch den Schaltbereich entlang der lateralen Ausdehnung erfolgt.

Also ist der strukturelle Aufbau des vorliegenden Phasenwechselspeichers derart, dass im Schaltbetrieb der Schaltstrom des Stromsignals lateral, also parallel zur Lithographie/Depositionsebene durch den Schaltbereich fließt. Die Stromführung des Stromsignals durch den Schaltbereich erfolgt also entlang der lateralen Ausdehnung.

Der Schaltbereich, also der Bereich innerhalb der Speichermaterialschicht innerhalb dem mittels dem Stromsignal ein Phasenwechsel zwischen einer kristallinen Phase und einer amorphen Phase und damit eine elektrische Widerstandsänderung des Phasenwechselmaterials induziert wird, ist also in einer Region zwischen dem ersten und zweiten elektrischen Kontakt angeordnet, in der die Stromführung des Stromsignals entlang der lateralen Ausdehnung ausgerichtet ist, so dass also der Schaltbereich entlang der lateralen Ausdehnung angeordnet ist.

Die laterale Stromführung des vorliegenden Phasenwechselspeichers bildet damit die Grundlage eines völlig neuen Konzepts eines "lateralen" Aufbaus eines Phasenwechselspeichers, der von den üblichen Ansätzen eines "vertikalen" Aufbaus, wie sie beispielsweise in der US 5,933,365 dargestellt sind, grundsätzlich abweicht. Üblicherweise wäre nämlich die Stromführung des Stromsignals entlang einer vertikalen Ausdehnung eines üblichen Phasenwechselspeichers, also senkrecht zur lateralen Ausdehnung, zwischen zwei in vertikaler Richtung übereinander angeordneten elektrischen Kontakten zu bevorzugen. Ein solcher "vertikaler" Aufbau wäre auch üblicherweise als Add-On auf den CMOS-Standard grundsätzlich zu bevorzugen, da er einen platzsparenden und kompakten Aufbau ermöglicht, so dass üblicherweise eine hohe Integrationsdichte mit einem vertikalen Aufbau erreicht werden könnte.

Demgegenüber hat die vorliegende Erfindung erkannt, dass für einen Phasenwechselspeicher zum Erreichen einer hohen Integrationsdichte, ein "lateraler" Aufbau bzw. eine "laterales" Konzept, das heißt eine im Schaltbereich entlang der lateralen Ausdehnung laufende Stromführung des Stromsignals und ein dem Rechnung tragender Strukturaufbau des Phasenwechselspeichers, zu bevorzugen ist. Bei einem Phasenwechselspeicher ist nämlich neben einem kompakten Aufbau die die Integrationsdichte maßgeblich begrenzende Größe der Stromverbrauch des Phasenwechselspeichers. Dieser ist bedingt durch den Schaltstrom des Stromsignals. Je geringer der Stromverbrauch eines Phasenwechselspeichers ist, desto höher läßt sich dieser integrieren, da die von den Transistoren geschalteten Schaltströme und damit auch die Transistoren selbst kleiner sein können.

Dabei ist zu beachten, dass eine stromdurchflossene Fläche eines Phasenwechselspeichers bei einem vertikalen Aufbau in der Lithographie/Depositionsebene liegt. In die stromdurchflossene Fläche eines Phasenwechselspeichers im vertikalen Aufbau, und damit in den Schaltstrom des Stromsignals, geht ausschließlich die Lithographie-Größe F (Minimum Feature Size) ein, so dass mindestens eine stromdurchflossene Fläche von F² und ein dementsprechend hoher Strom hingenommen werden muss.

Beim vorliegenden lateralen Aufbau des Phasenwechselspeichers ist dies grundsätzlich anders. Vorliegend ist die stromdurchflossene Fläche senkrecht zur lateralen Ausdehnung gebildet. Bei der Stromführung des Stromsignals durch den Schaltbereich entlang der lateralen Ausdehnung, geht die Lithographie-Größe F lediglich linear in die stromdurchflossene Fläche ein. Die stromdurchflossene Fläche eines Phasenwechselspeichers gemäß dem lateralen Aufbau ist außerdem nur noch durch die Dicke D der Speichermaterialschicht im Schaltbereich bestimmt. Die stromdurchflossene Fläche, und damit der Schaltstrom des Stromsignals, ist damit nur linear von der Lithographie-Größe F einerseits und der Schichtdicke D der Speichermaterialschicht im Schaltbereich andererseits, also durch F x D, gegeben. Entsprechend gering ist der benötigte Schaltstrom des Stromsignals.

Schichtdicken D können technologisch inzwischen deutlich unter 3nm und zudem extrem genau, bis auf atomare Präzision, das heißt etwa im Bereich von 0,5 nm kontrolliert und prozessiert werden. Demgegenüber ist die Lithographie-Größe F sehr viel aufwendiger zu verringern. Derzeitige Hochtechnologiespeicher nutzen Lithographie-Größen F im Bereich von 130 nm und in Zukunft werden Lithographie-Größen F im Bereich von 45 nm angestrebt. Dem steht eine technologisch ohne Weiteres erreichbare Schichtdickengröße D im Bereich von 10-20nm, vorteilhaft unterhalb von 10nm, insbesondere unterhalb von 5nm gegenüber. Bei dem vorliegenden Phasenwechselspeicher im lateralen Aufbau läßt sich damit die stromdurchflossenen Fläche des Schaltbereichs und damit der Schaltbereich selbst außerordentlich verkleinern im Vergleich zu einem Phasenwechselspeicher im vertikalen Aufbau. Die stromdurchflossene Fläche im lateralen Aufbau eines Phasenwechselspeichers, also die senkrecht zur lateralen Ausdehnung gebildete Durchtrittsfläche der Stromführung im Schaltbereich ist außerordentlich verkleinert im Vergleich zu einem Phasenwechselspeicher im vertikalen Aufbau. Der hier vorliegende Phasenwechselspeicher gemäß dem lateralen Aufbau wird damit immer energiesparender, hochintegrierbar und skalierbarer sein als übliche Phasenwechselspeicher.

Das Phasenwechselmaterial ist vorteilhaft ein chalkogenides Material, d.h. eine chalkogenide Legierung, also eine Legierung basierend auf den Materialien der Chalkogeniden (VI. Hauptgruppe des Periodensystems), und läßt sich prinzipiell mit Standard-Prozessen wie dem Ion-Milling, dem reaktiven Ionenätzen (Reactive Ion Etching) oder einem Plasmaätzprozess (Plasma Etching) prozessieren. Darüberhinaus ist vorliegend erkannt worden, dass ein chalkogenides Material der Speichermaterialschicht des vorliegenden Phasenwechselspeichers besonders vorteilhaft im Rahmen eines SputterProzesses deponiert werden kann.

Während bei üblichen Phasenwechselspeichem mit vertikalem Aufbau der elektrische Stromtransport und der thermische Abtransport aus dem Schaltbereich die gleiche (vertikale) Richtung haben verläuft beim hier vorliegenden Phasenwechselspeicher gemäß dem lateralen Konzept der thermische Fluss dominant in vertikaler Richtung während der elektrische Schaltstrom des Stromsignals in lateraler Richtung verläuft. Die Optimierung der Stromführung des Stromsignals im Rahmen des elektrischen Stromtransports hat unmittelbar Einfluss auf den Stromverbrauch des Phasenwechselspeichers. Die Optimierung der thermischen Umsetzung des Schaltstroms des Stromsignals im Schaltbereich hat Einfluss auf den Stromverbrauch und die Wiederbeschreibbarkeit bzw. die Geschwindigkeit eines Phasenwechselspeichers. Diese beiden wesentlichen Optimierungsparameter, elektrischer Stromverbrauch und thermischer Abtransport, werden bei dem hier vorliegenden Phasenwechselspeicher gemäß dem lateralen Konzept also unabhängig und eigenständig voneinander optimiert. Damit kann eine weitere Reduktion der Schaltströme und eine Verbesserung der allgemeinen Leistungsfähigkeit des vorliegenden Phasenwechselspeichers erreicht werden.

Erfindungsgemäß ist außerdem vorgesehen, dass der Schaltbereich bei einer Verengung zwischen dem ersten und zweiten elektrischen Kontakt in der Speichermaterialschicht angeordnet ist, wobei eine Abmessung der Verengung geringer ist, als eine Abmessung der Speichermaterialschicht am ersten oder zweiten elektrischen Kontakt. Dabei ist die Anordnung des Schaltbereichs zwischen dem ersten und zweiten elektrischen Kontakt im Wesentlichen durch die Anordnung der Verengung gegeben. Insbesondere ist der Schaltbereich durch die Verengung zwischen dem ersten und zweiten Kontakt in der Speichermaterialschicht gebildet. Die Abmessung der Verengung kann dabei jede Abmessung einer senkrecht zur lateralen Ausdehnung gebildeten Durchtrittsfläche der Stromführung im Schaltbereich sein. Je kleiner die Verengung der Speichermaterialschicht im Schaltbereich dimensioniert werden kann, desto geringer wird der für den thermisch induzierten Phasenwechsel und damit die Widerstandsänderung des Phasenwechselmaterials im Schaltbereich benötigte Schaltstrom des Stromsignals sein. Der wesentliche Vorteil des hier vorgeschlagenen Phasenwechselspeichers liegt darin, dass die Verengung aufgrund des lateralen Aufbaus durch die Dicke D der Speichermaterialschicht mitbestimmt ist, welche technologisch ohne Probleme weit unterhalb von 20nm, vorteilhaft unter 10nm oder 5 nm prozessiert werden kann. In der lateralen Ausdehnung des Phasenwechselspeichers ist die Verengung durch die Litographie-Größe F mitbestimmt. Dabei kann F zur Zeit ohne weiteres im Bereich von 130 nm liegen. Zukünftig werden für F Größen im Bereich von 45nm oder darunter angestrebt. Dabei gilt "Moore's Law", d.h. die Halbierung von F führt auch zu einer Halbierung von D.

Vorteilhafte Weiterbildungen der Erfindung sind den Unteransprüchen zu entnehmen und geben im Einzelnen vorteilhafte Möglichkeiten an, den vorgeschlagenen Phasenwechselspeicher im Rahmen des lateralen Aufbaus und Konzepts hinsichtlich Stromminimierung, gleichzeitig einfachem strukturellem Aufbau und hinsichtlich weiterer Vorteile im Einzelnen weiterzubilden.

Es erweist sich als besonders vorteilhaft, dass eine senkrecht zur lateralen Ausdehnung gebildete Durchtrittsfläche der Stromführung im Schaltbereich im Verhältnis zu einer Durchtrittsfläche der Stromführung am ersten oder zweiten elektrischen Kontakt verengt ist, wobei das Verhältnis der Durchtrittsflächen, also der Flächenkontrast, vorteilhaft zwischen 1:2 und 1:100 liegt. Eine derart starke Stromfokusierung in einen entsprechend kleinen durch die Verengung definierten Schaltbereich läßt sich vorteilhaft gemäß dem hier vorgeschlagenen lateralen Aufbau und Konzept des Phasenwechselspeichers ohne weiteres erreichen. Dies führt zu einer erheblichen Stromreduktion und damit zu einer möglichen Integrationsdichte, die mit einem bisher üblichen vertikalen Aufbau eines Phasenwechselspeichers nicht möglich wäre.

Die Verengung kann in der lateralen und/oder vertikalen Ausdehnung des Phasenwechselspeichers realisiert sein. Insbesondere erweist es sich als vorteilhaft, dass eine Abmessung der Verengung in der lateralen Ausdehnung geringer ist, als eine Abmessung der Speichermaterialschicht in der lateralen Ausdehnung am ersten oder zweiten elektrischen Kontakt. Dabei hat sich eine doppel-kegelförmige oder H-förmige Struktur als besonders geeignet erwiesen.

Vorteilhafterweise kann auch eine Abmessung der Verengung in der vertikalen Ausdehnung geringer sein, als eine Abmessung der Speichermaterialschicht in der vertikalen Ausdehnung am ersten oder zweiten elektrischen Kontakt. Dies kann durch eine beliebig ausgestaltete Schichtdickenverringerung der Speichermaterialschicht in einer Region zwischen dem ersten und zweiten elektrischen Kontakt erfolgen, die dann im wesentlichen den Schaltbereich bildet.

Gemäß den oben aufgeführten Weiterbildungen der Erfindung wird also der Schaltbereich vorteilhaft durch eine Einschnürung oder Verengung der lateralen und/oder vertikalen Ausdehnung der Speichermaterialschicht, also im Phasenwechselmaterial selbst gebildet und angeordnet. Die höchste Stromdichte tritt damit im Schaltbereich auf und induziert damit thermisch innerhalb eines durch die Lithographie-Größe F und Schichtdicke D größenordnungsmäßig bestimmten Volumens des Schaltbereichs den Phasenwechsel zwischen der kristallinen Phase und der amorphen Phase und damit die Widerstandsänderung des Phasenwechselmaterials innerhalb der Speichermaterialschicht.

Dies führt auf eine weitere besonders bevorzugte Weiterbildung der Erfindung, bei der der erste und/oder der zweite elektrische Kontakt unmittelbar an die Speichermaterialschicht grenzen und der Schaltbereich beabstandet vom ersten und/oder zweiten Kontakt in der Speichermaterialschicht gebildet ist.
Da die den Schaltbereich definierende Verengung im Phasenwechselmaterial der Speichermaterialschicht selbst und gleichzeitig beabstandet von den direkt an der Speichermaterialschicht angebrachten elektrischen Kontakten angeordnet ist, wirkt also das den Schaltbereich umgebende Phasenwechselmaterial in der Speichermaterialschicht thermisch isolierend zwischen dem Schaltbereich und den elektrischen Kontakten. Aufgrund des lateralen Konzepts und Aufbaus des vorliegenden Phasenwechselspeichers können die hohen Temperaturen und die schnellen Temperaturänderungen des Schaltbereichs fern von den Kontaktmaterialien der elektrischen Kontakte gehalten werden.

Der thermische Abstand zwischen Schaltbereich und den elektrischen Kontakten ist also einerseits so groß gewählt, dass der Schaltbereich und die elektrischen Kontakte thermisch praktisch entkoppelt sind. Dies hat den Vorteil, dass ein Energieabfluss vom Schaltbereich zum elektrischen Kontakt hin praktisch unterbunden ist, also zu einer effizienten Ausnutzung des Schaltstroms des Stromsignals hinsichtlich der thermischen Phasenumwandlung im Schaltbereich führt, weil sich dieser effizienter bis auf die Phasenwechseltemperatur aufheizen kann. Des Weiteren werden die hohen Temperaturen des Schaltbereichs fern der Kontaktmaterialien der elektrischen Kontakte gehalten, so dass eine atomare Interdiffusion der Kontaktmaterialien verhindert wird. Dadurch erweisen sich die elektrischen Kontakte, obwohl direkt an der Speichermaterialschicht angebracht, als besonders langlebig.

Zum anderen wird der thermische Abstand des Schaltbereichs zu den elektrischen Kontakten so klein gewählt, dass im Normalzustand eine möglichst gute Stromleitfähigkeit zwischen den elektrischen Kontakten gegeben ist. Es hat sich gezeigt, dass der thermische Abstand des Schaltbereichs zu einem der elektrischen Kontakte besonders vorteilhaft zwischen 20 bis 50 nm liegt. Dies garantiert eine ausreichend große Temperaturreduktion zwischen Schaltbereich und elektrischen Kontakten und erlaubt gleichzeitig eine ausreichende Stromleitfähigkeit.

Durch die hier beschriebene besonders bevorzugte Weiterbildung der Erfindung können also übliche Kontaktmaterialien der Halbleiterindustrie Verwendung finden, wobei der vorgeschlagene Phasenwechselspeicher eine verbesserte Langzeitstabilität und eine besonders einfache Prozessführung bei der Herstellung erlaubt. Bisher übliche aufwendige Kontaktschichtsysteme zur Abschirmung oder Isolierung der elektrischen Kontakte vom Schaltbereich unter Verwendung sogenannter "Heater"-Schichten oder Diffusionsbarrieren (meistens aus TiWNi und Graphit) wird damit vermieden.

Bei den oben aufgeführten Weiterbildungen der Erfindung ergibt sich, dass der Schaltbereich vom Stromsignal insbesondere dann entlang der lateralen Ausdehnung durchsetzt werden kann, wenn der Schaltbereich derart zwischen den elektrischen Kontakten angeordnet ist, dass wenigstens ein thermischer Abstand des Schaltbereichs zu jedem der elektrischen Kontakte im Bereich von 20 bis 50nm eingehalten werden kann. Ein Schaltbereich ist zwischen elektrischen Kontakten insbesondere dann entlang einer lateralen Ausdehnung angeordnet, wenn die Stromführung im Schaltbereich, oder gegebenenfalls darüber hinaus, wenigstens 20nm, vorteilhaft 40nm, im wesentlichen parallel zur Lithographie/Depositionsebene erfolgt.

Dementsprechend muss ein Schaltbereich nicht notwendigerweise auf einer direkten Verbindungslinie zwischen einem ersten und zweiten elektrischen Kontakt angeordnet sein, sondern ausreichend ist, dass der Schaltbereich in einer Region angeordnet ist, die entlang der lateralen Ausdehnung zwischen einem ersten und zweiten elektrischen Kontakt liegt. Dabei ist vorteilhaft der erste und zweite elektrische Kontakt so angeordnet, dass eine Stromführung des Stromsignals durch den Schaltbereich besonders einfach entlang der lateralen Ausdehnung erfolgen kann. Gemäß einer bevorzugten Weiterbildung der Erfindung ist der Abstand zwischen dem ersten und zweiten elektrischen Kontakt im wesentlichen entlang der lateralen Ausdehnung ausgerichtet. Dabei sollte eine Verbindungslinie zwischen den elektrischen Kontakten im wesentlichen parallel zur Lithographie/Depositionsebene verlaufen und wenn möglich nicht mehr als 45° von dieser Ebene abweichen. Im Einzelnen kann die Anordnung der elektrischen Kontakte je nach konstruktiver Ausführung des Phasenwechselspeichers gewählt werden.

Dabei erweist es sich als besonders vorteilhaft für vielerlei Anwendungen, dass der Abstand zwischen dem ersten und zweiten elektrischen Kontakt entlang der lateralen Ausdehnung ausgerichtet ist, wobei der erste elektrische Kontakt unterhalb der Speichermaterialschicht angeordnet ist und der zweite elektrische Kontakt oberhalb der Speichermaterialschicht angeordnet ist. Um eine Stromführung des Stromsignals durch den Schaltbereich entlang der vertikalen Ausdehnung zu vermeiden, ist dabei der erste elektrische Kontakt und der zweite elektrische Kontakt jedenfalls nicht entlang einer vertikalen Ausdehnung des Phasenwechselspeichers angeordnet. Die Anordnung eines elektrischen Kontakts unterhalb der Speichermaterialschicht hat den Vorteil, dass die Kontaktierung des Phasenwechselspeichers substratseitig erfolgen kann.

Für weitere Anwendungen ist der Abstand vorteilhaft zwischen dem ersten und zweiten elektrischen Kontakt entlang der lateralen Ausdehnung ausgerichtet, wobei der erste und der zweite elektrische Kontakt oberhalb der Speichermaterialschicht angeordnet sind.

Insbesondere erweist sich eine Anordnung des Schaltbereichs in einer Region zwischen dem ersten und zweiten elektrischen Kontakt und unterhalb des ersten und/oder zweiten elektrischen Kontakts entlang der lateralen Ausdehnung als vorteilhaft.

Noch eine weitere besonders bevorzugte Weiterbildung der Erfindung besteht darin, dass unmittelbar an die Speichermaterialschicht ein Keimbildungsbereich grenzt. Es hat sich nämlich gezeigt, dass beim Schaltvorgang im Schaltbereich das Kristallisieren des amorphisierten Materials im Vergleich zur Amorphisierung der langsamere Prozess ist. Dieser kann bis zu 200ns andauern. Zum Kristallisieren bilden sich zunächst Keime, die dann wachsen bis der Schaltbereich weitgehend kristallisiert ist. Ein unmittelbar an die Speichermaterialschicht, vorzugsweise direkt an den Schaltbereich grenzender Keimbildungsbereich verkürzt jedenfalls die Keimbildung und ermöglicht es bei der vorliegenden Weiterbildung der Erfindung eine Schaltzeit jedenfalls auf bis zu 20 ns zu verkürzen.

Vorzugsweise ist der Keimbildungsbereich in Form einer Schicht ausgebildet. Das Keimbildungsmaterial kann ein auf einem Nitrid basierendes Material sein. Prozessiert wird ein Keimbildungsbereich vorzugsweise dadurch dass die Prozessierfläche während der Deposition der Speichermaterialschicht, also z.B. der Chalkogenidschicht, kurzzeitig einer N₂-Prozessatmosphäre ausgesetzt wird. Eine sich entlang der lateralen Ausdehnung erstreckende Keimbildungsschicht läßt sich besonders vorteilhaft im Rahmen des hier vorgeschlagenen lateralen Konzepts eines Phasenwechselspeichers verwirklichen. Dagegen wäre dies im Rahmen eines vertikalen Aufbaus nicht möglich, da eine Nitrid-Schicht elektrisch isolierende Eigenschaften hat und jedenfalls eine vertikale Stromführung hemmt.

Vorteilhaft sind bei dem vorgeschlagenen Phasenwechselspeicher der erste und zweite elektrische Kontakt und die Speichermaterialschicht Teil einer auf einem Substrat aufgebrachten MESA-Struktur. Erfindungsgemäß ist die Speichermaterialschicht über eine thermische Barriere in Form einer auf ZnS:SiO₂-basierenden Schicht von einer Wärmesenke isoliert, dies insbesondere im Unterschied zu WO 2004/057618 A2. Zwischen der Speichermaterialschicht und der thermischen Barriere kann vorteilhaft eine Keimbildungsschicht, insbesondere eine auf Nitrid-Basis, angeordnet sein. Die thermische Barriere ist vorteilhaft eine auf ZnS:SiO₂basierende Schicht. Das Phasenwechselmaterial ist vorteilhaft ein chalkogenides Material, z.B. ein GeSbTe-basiertes Material. Die Wärmesenke kann durch das Substrat-Material, insbesondere ein Si-Substrat, gebildet sein. In diesem Fall wäre die Wärmesenke unterhalb des Phasenwechselspeichers angeordnet. Als Wärmesenke kann auch eine Metallschicht dienen, die unterhalb oder oberhalb des Phasenwechselspeichers angeordnet sein kann.

Die Erfindung führt in einer Variante auch auf eine Phasenwechselspeicheranordnung mit einem oder mehreren Phasenwechselspeichem nach einer der vorhergehenden Weiterbildungen, wobei von jedem Phasenwechselspeicher jeweils einer der elektrischen Kontakte mit den anderen der jeweils einen elektrischen Kontakte zusammen auf gleichem elektrischen Potenzial liegt. Das heißt jeweils ein Kontakt jedes Phasenwechselspeichers kann beispielsweise auf Masse liegen. Auf diese Weise lassen sich unterschiedlichste Anordnungen wie in der Detailbeschreibung beispielhaft erläutert realiseren.

Zur weiteren Ausgestaltung eines Phasenwechselspeichers oder einer Phasenwechselspeicheranordnung gemäß einer der erläuterten Weiterbildungen kann ein Phasenwechselspeicher außer dem ersten und zweiten elektrischen Kontakt je nach Bedarf auch einen oder mehrere weitere elektrische Kontakte aufweisen.

Die Erfindung führt auch auf eine Phasenwechselspeicherzelle mit einem Phasenwechselspeicher gemäß einer der genannten Weiterbildungen der Erfindung und/oder einer Phasenwechselspeicheranordnung, wobei eine Selektionseinheit mit nicht-linearer Stromspannungskennlinie vorgesehen ist. Die Selektionseinheit ist aufgrund ihrer nicht-linearen Strom-Spannungskennlinie zum Ansteuern des Phasenwechselspeichers, z.B. im Rahmen eines Arrays, vorgesehen. Die Selektionseinheit kann insbesondere eine Diode oder ein Transistor sein. Bei einem Array solcher Phasenwechselspeicherzellen werden z.B. für eine X/Y-Adressierung alle Zellen einer Zeile über einen Adressierkontakt angesprochen sowie über einen weiteren Adressierkontakt alle Zellen einer Spalte. Nur die über eine bestimmte Zeile und eine bestimmte Spalte gleichzeitig angesprochene Zelle wird adressiert, da aufgrund der nicht-linearen Strom-Spannungskennlinie nur für die adressierte Zelle ein Adressiersignal (z.B. eine Spannung) oberhalb eines Threshholdsignals liegt.

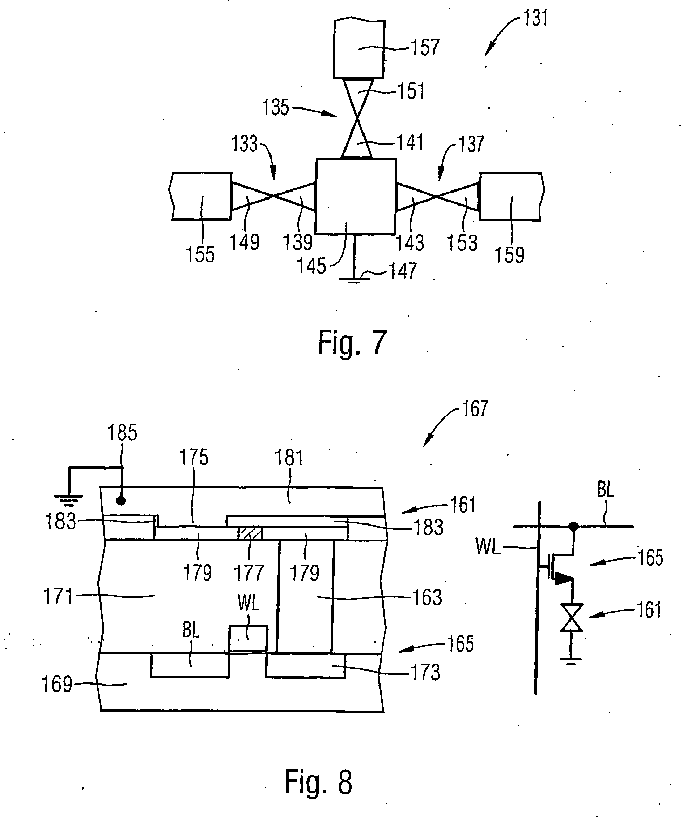

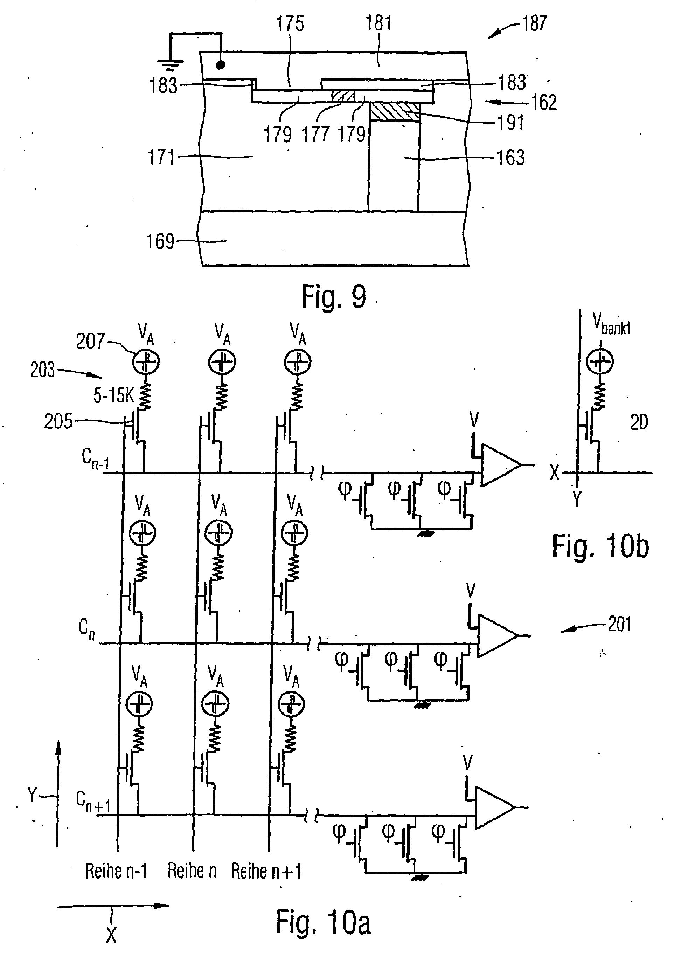

Grundsätzlich kann eine Selektionseinheit extern zum Phasenwechselspeicher angeordnet sein. Es erweist sich darüber hinaus als besonders vorteilhaft, dass eine Selektionseinheit im Phasenwechselspeicher selbst und/oder in der Phasenwechselspeicheranordnung selbst integriert ist. Insbesondere kann eine Selektionseinheit zwischen der Speichermaterialschicht und dem ersten elektrischen Kontakt und/oder zwischen der Speichermaterialschicht und dem zweiten elektrischen Kontakt angeordnet sein. Dies ist in den Fig. 8 und 9 der Detailbeschreibung im Einzelnen erläutert. Eine solche Weiterbildung der Erfindung macht es überflüssig eine Selektionseinheit extern zum Phasenwechselspeicher zu prozessieren. Vielmehr kann diese vorteilhaft im Aufbau des Phasenwechselspeichers integriert sein. Für diese Art der Weiterbildung der Erfindung erweist sich insbesondere ein Phasenwechselspeicher als geeignet, bei dem der erste elektrische Kontakt unterhalb der Speichermaterialschicht angeordnet ist. Insbesondere für ein zweidimensionales (2D)-Phasenwechselspeicherzellen-Array eignet sich die Anordnung einer Diode als Selektionseinheit zwischen dem ersten unterhalb der Speichermaterialschicht angeordneten Kontakt und der Speichermaterialschicht. Insbesondere für ein dreidimensionales (3D)-Phasenwechselspeicherzellen-Array eignet sich die Anordnung einer Diode als Selektionseinheit zwischen dem zweiten oberhalb der Speichermaterialschicht angeordneten Kontakt und der Speichermaterialschicht.

Die Erfindung führt auch auf ein zweidimensionales (2D)-Phasenwechselspeicherzellen-Array, bei dem eine Anzahl von zweidimensional verschalteten und einzeln adressierbaren Phasenwechselspeicherzellen gemäß einer der vorhergehenden Weiterbildungen angeordnet sind.

Im Rahmen eines dreidimensionalen (3D)-Phasenwechselspeicherzellen-Arrays lässt sich eine Anzahl von übereinander angeordneten Speicherschichten in Form von 2D-Phasenwechselspeicherzellen-Arrays gemäß einer der vorhergehenden Weiterbildungen der Erfindung verschalten.

Dabei erweist es sich als besonders vorteilhaft, dass jeweils direkt übereinander angeordnete Phasenwechselspeicher und/oder Zellen über ein gemeinsames Via kontaktiert sind. Eine Kontaktierung über ein gemeinsames Via ist besonders vorteilhaft im Rahmen des vorliegenden lateralen Konzepts und Aufbaus eines Phasenwechselspeichers realisierbar, während im Rahmen eines vertikalen Aufbaus eines üblichen Phasenwechselspeichers, wie in der US 6,525,953 B1 jede Spalte und Zeile jedes Phasenwechselspeicherzellen-Arrays bei allen Speicherschichten des 3D-Arrays einzeln kontaktiert werden muss. Dagegen wird bei dem vorliegenden (3D)-Phasenwechselspeicherzellen-Array mit Phasenwechselspeichern gemäß dem lateralen Konzept und Aufbau jede Spalte und Zeile für alle Speicherschichten gemeinsam nur einmal kontaktiert.

Gemäß einer Weiterbildung des 3D-Phasenwechselspeicherzellen-Arrays nach dem lateralen Konzept und Aufbau sind zur Adressierung eines ausgewählten Phasenwechselspeichers eines 2D-Phasenwechselspeicher-Zellen-Array jeweils dazu direkt übereinander angeordnete Phasenwechselspeicherzellen über das gemeinsame Via auf ein erstes Potenzial schaltbar und dabei alle weiteren Phasenwechselspeicherzellen eines jeden weiteren 2D-Phasenwechselspeicherzellen-Arrays auf ein zweites Potenzial schaltbar. Diese Art der Verschaltung erweist sich als besonders vorteilhaft für die dreidimensionale Adressierung des vorliegenden 3D-Phasenwechselspeicherzellen-Arrays. Zum Zwecke der Zeilen/Spalten (X/Y)-Adressierung für die Ebenen können über das gemeinsame Via alle Phasenwechselspeicherzellen entlang einer Z-Richtung auf ein festes Potenzial, als erstes Potenzial, gelegt werden und so eine X/Y Auswahl getroffen werden. Die Z-Adressierung erfolgt dabei, indem beim ausgewählten 2D-Phasenwechselspeicherzellen-Array alle Phasenwechselspeicherzellen auf ein freies Potenzial, als zweites Potenzial, z.B. auf Masse, gelegt werden. Die übrigen 2D-Phasenwechselspeicherzellen-Arrays befinden sich in einem "floating state / high impedance state".

Die Erfindung führt auch auf einen Elektronikbaustein mit integrierter Speicher- und/oder Logik-Funktion, mit einem Phasenwechselspeicher und/oder einer Phasenwechselspeicheranordnung und/oder einer Phasenwechselspeicherzelle und/oder einem Phasenwechselspeicherzellen-Array nach einer der oben genannten Weiterbildungen der Erfindung. Dies kann insbesondere ein Application-Specific-Integrated-Circuit (ASIC) mit integrierter Speicher- und/oder Logik-Funktion sein. Solche Elektronikbausteine finden insbesondere Verwendung in Datenverarbeitungs-, Datenübertragungs- und "Consumer Electronics"-Geräten wie Handys, Computer sowie Video- und/oder Digitalkameras.

Ausführungsbeispiele der Erfindung werden nun nachfolgend anhand der Zeichnung beschrieben. Diese soll die Ausführungsbeispiele nicht notwendiger Weise maßstäblich darstellen, vielmehr ist die Zeichnung, wozu Erläuterung dienlich, in schematisierter und und/oder leicht verzerrter Form ausgeführt. Im Hinblick auf Ergänzungen der aus der Zeichnung unmittelbar erkennbaren Lehren wird auf den einschlägigen Stand der Technik verwiesen. Dabei ist zu berücksichtigen, dass vielfältige Modifikationen und Änderungen betreffend die Form und das Detail einer Ausführungsform vorgenommen werden können, ohne von der allgemeinen Idee der Erfindung abzuweichen. Die in der Beschreibung, in der Zeichnung sowie in den Ansprüchen offenbarten Merkmale der Erfindung können sowohl einzeln als auch in beliebiger Kombination für die Ausgestaltung der Erfindung wesentlich sein. Die allgemeine Idee der Erfindung ist nicht beschränkt auf die exakte Form oder das Detail der im folgenden gezeigten und beschriebenen bevorzugten Ausführungsform oder beschränkt auf einen Gegenstand, der eingeschränkt wäre im Vergleich zu den in den Ansprüchen beanspruchten Gegenstand.

Die Figuren der Zeichnung zeigen im einzelnen in:
- FIG 1 :: eine den Phasenwechsel zwischen einer kristallinen Phase und einer amorphen Phase und damit eine Widerstandsänderung des Phasenwechselmaterials im Schaltbereich illustrierende Widerstands-Temperatur-Grafik;
- FIG 2 :: ein schematisierter Aufbau eines Phasenwechselspeichers, bei dem der Schaltbereich entlang einer lateralen Ausdehnung des Phasenwechselspeichers zwischen dem ersten und zweiten elektrischen Kontakt angeordnet ist, wobei eine Stromführung des Stromsignals durch den Schaltbereich entlang der lateralen Ausdehnung erfolgt;
- FIG 3 :: eine bevorzugte erste Ausführungsform des vorgeschlagenen Phasenwechselspeichers, bei dem der erste elektrische Kontakt unterhalb der Speichermaterialschicht angeordnet ist und der zweite elektrische Kontakt oberhalb des Speichermaterialschicht angeordnet ist;
- FIG 4 :: eine zweite bevorzugte Ausführungsform des vorgeschlagenen Phasenwechselspeichers, bei dem der erste und der zweite elektrische Kontakt oberhalb der Speichermaterialschicht angeordnet ist;
- FIG 5 :: eine erste schematisiert dargestellte Prozessierfolge für eine weitere bevorzugte Ausführungsform des vorgeschlagenen Phasenwechselspeichers;
- FIG 6 :: eine zweite schematisiert dargestellte Prozessierfolge noch einer weiteren bevorzugten Ausführungsform des vorgeschlagenen Phasenwechselspeichers;
- FIG 7 :: eine bevorzugte Ausführungsform einer Phasenwechselspeicheranordnung, bei der von jedem Phasenwechselspeicher jeweils einer der elektrischen Kontakte mit den anderen der jeweils einen elektrischen Kontakte zusammen auf gleichen elektrischen Potenzial liegt;
- FIG 8 :: eine schematisiert dargestellte besonders bevorzugte Ausführungsform einer Phasenwechselspeicherzelle auf einem CMOS-Steuertransistor mit Ersatzschaltbild;
- FIG 9 :: eine modifizierte schematisiert dargestellte besonders bevorzugte Ausführungsform einer Phasenwechselspeicherzelle, bei der eine Diode als Selektionseinheit im Phasenwechselspeicher integriert ist;
- FIG 10 :: ein Ersatzschaltbild für eine besonders bevorzugte Ausführungsform eines 2D-Phasenwechselspeicherzellen-Arrays;
- FIG 11 :: eine schematisierte Darstellung einer besonders bevorzugten Ausführungsform eines 3D-Phasenwechselspeicherzellen-Arrays mit Ersatzschaltbild;
- FIG 12 :: ein schematisiert dargestellter Elektronikbaustein.

Figur 1 zeigt eine mit einer Heizrate von 23°C pro Minute aufgenommene Widerstands-Temperatur-Grafik 1, die den Phasenwechsel zwischen einer kristallinen Phase 3 und einer amorphen Phase 5 und damit eine Widerstandsänderung 7 eines Phasenwechselmaterials in einem Schaltbereich einer Speichermaterialschicht eines Phasenwechselspeichers im Prinzip verdeutlicht. Die Widerstandsänderung 7 wird in einem Phasenwechselspeicher mittels einem Stromsignal über eine Temperaturänderung 9 thermisch induziert. Ein zu bevorzugendes chalkogenides Phasenwechselmaterial kann bei Raumtemperatur sowohl in einer stabilen kristallinen Phase 3 als auch in einer metastabilen amorphen Phase 5 vorliegen. Die reversible Phasenumwandlung im Rahmen einer Amorphisierung oder Kristallisation, zwischen beiden Phasen 5, 3 wird von einer signifikanten Änderung im elektrischen Widerstand 7 begleitet und damit zur Speicherung einer digitalen information genutzt. Dabei zeigt ein Phasenwechselmaterial vorteilhaft einen extrem großen dynamischen Bereich einer Widerstandsänderung 7, der mehr als drei Größenordnungen umfassen kann. Dies hat den Vorteil, dass beispielsweise auch eine Multi-Bit-Speicherung in einer Phasenwechselspeicherzelle möglich ist. Materialbedingt kann eine Phasenwechselspeicherzelle auch mit niedrigen Strömen ohne Zerstörung der gespeicherten Informationen gelesen werden (Non-destructive Readout). Daneben ist es auch bei dem hier vorliegenden lateralen Konzept und Aufbau eines Phasenwechselspeichers je nach Stromzufuhr möglich, einen Phasenübergang in nur einem Teil oder dem gesamten Schaltbereich zu bewirken, so dass damit eine mehrwertige Logik abhängig von der Stromzufuhr realisierbar ist. Dies kann derart erfolgen, daß z.B. bei einem ersten geringen Strom nur ein erster kleinerer Teil des Schaltbereichs phasenumgewandelt wird und bei einem zweiten, höheren Strom ein zweiter größerer Teil des Schaltbereichs phasenumgewandelt wird.

Neben den niedrigeren Produktionskosten des hier vorgestellten lateralen Konzepts im Vergleich zum vertikalen Konzept erweist sich insbesondere die Integrationseigenschaft als wesentlich besser als bei anderen Konzepten, d. h. aufgrund des geringeren Schaltstrombedarfs des hier vorliegenden Phasenwechselspeichers im lateralen Konzept werden in Zukunft höhere Integrationsdichten mit immer weniger Stromverbrauch realisierbar sein.

Die Graphik der Figur 1 zeigt eine Abfolge von quasistatischen Zuständen, sodaß die dynamischen Phasenumwandlungsprozeße einer Kristallisation 13 und einer Amorphisierung 11 immerhin im Prinzip verdeutlicht werden können. Die Prozeße sind hier jedenfalls durch entsprechende Pfeilrichtungen angedeutet. Dabei ist der Kristallisitionsprozeß 13 der langsamere Prozeß. Der Amorphisierungsprozeß 11 ist dagegen der schnellere Prozeß, der nicht wirklich durch eine Abfolge von quasistatischen Zuständen beschrieben werden kann. In der Graphik ist die Amorphisierung 11 durch eine gestrichelte Linie angedeutet.

Die Figur 1 kann für den Betriebsfall eines Phasenwechselspeichers das Prinzip veranschaulichen. Im Betriebsfall liegen die Temperaturschwankungen 9 um ca. 300°C über den in der Graphik gezeigten.

Im Einzelnen wird der Phasenwechsel zwischen der kristallinen Phase 3 und der amorphen Phase 5 im Phasenwechselmaterial durch geschicktes Heizen und Abkühlen im Rahmen einer, vorteilhaft gepulsten, Schaltstromzuführung eines Stromsignals erreicht. Für die Amorphisierung 11 wird das Phasenwechselmaterial zunächst aufgeschmolzen. Durch eine schnelle Abkühlung der Schmelze erstarrt diese im amorphen Zustand 5. Eine Bedingung für die Amorphisierung 11 ist, dass die Abkühlrate von der Schmelztemperatur bis zu einer Glastemperatur, welche in der Regel bei ca. 2/3 der Schmelztemperatur liegt, größer ist als die Keimbildungs- und Wachstumsrate im Temperaturbereich. Die Abkühlrate von der Glastemperatur bis zur Raumtemperatur spielt für die Amorphisierung 11 keine Rolle. Der typische Wert einer kritischen Abkühlrate liegt zwischen 10⁹ bis 10¹⁰ K/sec . Obwohl der amorphe Zustand 5 meta-stabil ist, beträgt die Stabilitätsdauer mehr als 10 Jahre bei Raumtemperatur, was eine auch für Langzeitspeicherungen unkritische Stabilitätsdauer darstellt.

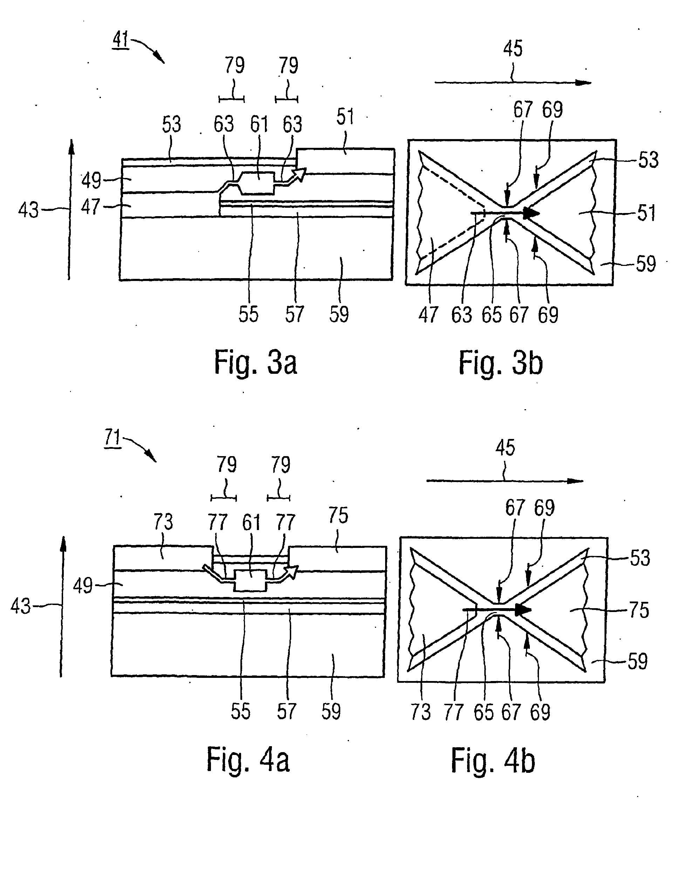

Die Kristallisation 13 des amorphisierten Materials 5 zum kristallinen Zustand 3 erfolgt durch Erwärmung über die Glastemperatur, wobei die maximale Temperatur unterhalb der Schmelztemperatur verbleibt. In diesem Temperaturbereich ist die Keimbildungs-und Wachstumsrate maximal. Bei dem hier vorliegenden Konzept wird im Rahmen einer Ausbildungsform wie anhand der Figuren 3 und 4 erläutert, vorteilhaft ein Keimbildungsbereich unmittelbar an die Speichermaterialschicht angrenzend angeordnet, da auf diese Weise die Keimbildung verkürzt werden kann und eine Schaltzeit bei der Kristallisation auf bis zu 20ns verkürzen kann, während sonst üblicherweise Schaltzeiten im Rahmen von 200ns erreichbar sind.

Die Amorphisierung 11 und die Kristallisation 13 finden also jeweils bei einer geeigneten hohen Temperatur und mit unterschiedlicher Dynamik statt. Die Phasenumwandlungen 11, 13 in einem Phasenwechselspeicher werden bei der hier erläuterten Ausführungsform durch drei Pulse für einen Lesevorgang (Read), eine Kristallisation 13 (Set) und eine Amorphisierung 11 (Reset) genutzt.

Für die Set-Operation wird ein verhältnismäßig "langer" Schaltstromimpuls verwendet, dessen typische Pulslängen im Bereich von 50ns liegen. Durch ohmsche Verluste steigt die Temperatur 9 im Schaltbereich über die Glastemperatur an. So lange der Puls anliegt wird der Schaltbereich kristallisiert.

Für die Reset-Operation wird der kristalline Schaltbereich durch einen verhältnismäßig "kurzen" Puls über die Schmelztemperatur aufgeheizt, wobei typische Pulslängen unterhalb von 10ns liegen. Durch rasches Abkühlen nach Abschalten des Pulses erstarrt die Schmelze im amorphen Zustand 5.

Für die Read-Operation der gespeicherten Informationen wird eine Antwort, z.B. ein Spannungszustand, des Phasenwechselspeichers/Phasenwechselspeicherzelle auf einen schwachen Strompuls gemessen. Die Pulslänge hängt dabei nur von der Integrationszeit der Strommessstufe ab und liegt im Bereich von etwa 10ns.

Für weitergehende grundlegende Erläuterungen zur physikalischen Wirkungsweise eines Phasenwechselspeichers wird auf den oben erwähnten Artikel "Nonvolatile, High Density, High Performance Phase-Change Memory" von Tyson, Wicker, Lowrey, Hudgens und Hunt in IEEE 2000, Seiten 385 bis 390, verwiesen.

Figur 2 zeigt den schematisierten Aufbau eines Phasenwechselspeichers 21 mit einer Speichermaterialschicht 23 eines Phasenwechselmaterials und einem ersten elektrischen Kontakt 25 und einem zweiten elektrischen Kontakt 27, die über einen Abstand 29 voneinander beabstandet sind. Über die Kontakte 25, 27 ist ein Schaltbereich 31 der Speichermaterialschicht 23 von einem Stromsignal durchsetzbar. Mittels dem Stromsignal ist ein beispielhaft anhand der Figur 1 erläuterter Phasenwechsel 11, 13 zwischen einer kristallinen Phase 3 und einer amorphen Phase 5 und damit eine Widerstandsänderung 7 des Phasenwechselmaterials im Schaltbereich 31 mittels einer Temperaturänderung 9 thermisch induzierbar. Gemäß dem vorliegenden lateralen Konzept und Aufbau des Phasenwechselspeichers ist der Schaltbereich 31 entlang einer lateralen Ausdehnung 33 des Phasenwechselspeichers 21 zwischen dem ersten elektrischen Kontakt 25 und dem zweiten elektrischen Kontakt 27 angeordnet, wobei eine Stromführung 35 des Stromsignals durch den Schaltbereich 31 entlang der lateralen Ausdehnung 33 erfolgt.

Figur 3 zeigt eine erste bevorzugte Ausführungsform eines vorgeschlagenen Phasenwechselspeichers 41. In der Ansicht (a) ist im Schnitt der Aufbau der Ausführungsform entlang einer vertikalen Ausdehnung 43 des Phasenwechselspeichers 41 gezeigt. In der Ansicht (b) ist die Ausführungsform entlang einer lateralen Ausdehnung 45 des Phasenwechselspeichers 41 gezeigt. Vorliegend ist der erste elektrische Kontakt 47 unterhalb der Speichermaterialschicht 49 angeordnet und der zweite elektrische Kontakt 51 oberhalb der Speichermaterialschicht 49 angeordnet. Bei dieser Ausführungsform des Phasenwechselspeichers 41 sind die elektrischen Kontakte 47, 51 metallisch. Der aktive Bereich des Phasenwechselspeichers 41 ist mit Siliziumoxid (SiO₂ passiviert 53. Die Speichermaterialschicht 49 besteht bei dieser Ausführungsform aus einem GeSbTe-basierten Phasenwechselmaterial. Eine darunter liegende Nitrid-Schicht 55 unterstützt die Kristallkeimbildung, um ein schnelleres und reproduzierbareres Schalten des Schaltbereichs zu ermöglichen. Eine wiederum darunter liegende ZnS:SiO₂-Schicht 57 dient als einstellbare thermische Barriere und elektrische Isolation zur Silizium-Wärmesenke 59, die bei dieser Ausführungsform durch ein p-Si-Substrat gebildet ist. Der Schaltbereich 61 ist entlang einer lateralen Ausdehnung 45 des Phasenwechselspeichers 41 zwischen dem ersten elektrischen Kontakt 47 und dem zweiten elektrischen Kontakt 51 angeordnet, wobei eine Stromführung 63 des Stromsignals durch den Schaltbereich 61 entlang der lateralen Ausdehnung 45 erfolgt. Insbesondere ist bei dieser Ausführungsform der Schaltbereich 61 bei einer Verengung 65 zwischen dem ersten elektrischen Kontakt 47 und dem zweiten elektrischen Kontakt 51 in der Speichermaterialschicht 49 angeordnet. Die Abmessung 67 der Verengung 65 ist dabei geringer als eine Abmessung 69 der Speichermaterialschicht 49 am ersten elektrischen Kontakt 47 oder zweiten elektrischen Kontakt 51. Die Verengung 65 ist bei dieser Ausführungsform in der lateralen Ausdehnung gebildet.

Figur 4 zeigt eine zweite bevorzugte Ausführungsform 71 des vorgeschlagenen Phasenwechselspeichers, bei dem im Unterschied zur Figur 3 der erste elektrische Kontakt 73 und der zweite elektrische Kontakt 75 oberhalb der Speichermaterialschicht 49 angeordnet sind. Der Schaltbereich 61 ist bei dieser Ausführungsform 71 in einer Region zwischen und unterhalb dem ersten elektrischen Kontakt 73 und zweiten elektrischen Kontakt 75 entlang der lateralen Ausdehnung 45 angeordnet. Die Ansichten (a) und (b) der Figur 4 zeigen eine im Vergleich zur Figur 3 modifizierte Stromführung 77 des Stromsignals durch den Schaltbereich 61 entlang der lateralen Ausdehnung 45 des Phasenwechselspeichers 71. Im übrigen werden für funktionsgleiche Elemente dieser Ausführungsform die gleichen Bezugszeichen wie in Figur 3 benutzt.

Sowohl in Figur 3 als auch in Figur 4 grenzt der erste elektrische Kontakt 73, 47 und/oder der zweite elektrische Kontakt 75, 51 unmittelbar an die Speichermaterialschicht 49 und der Schaltbereich 61 ist beabstandet vom ersten elektrischen Kontakt 73, 47 und/oder zweiten elektrischen Kontakt 75, 51 in der Speichermaterialschicht 49 gebildet. Der thermische Abstand 79 des Schaltbereichs 61 von den elektrischen Kontakten 73, 47 und 75, 51 beträgt vorzugsweise zwischen 20nm und 50nm.

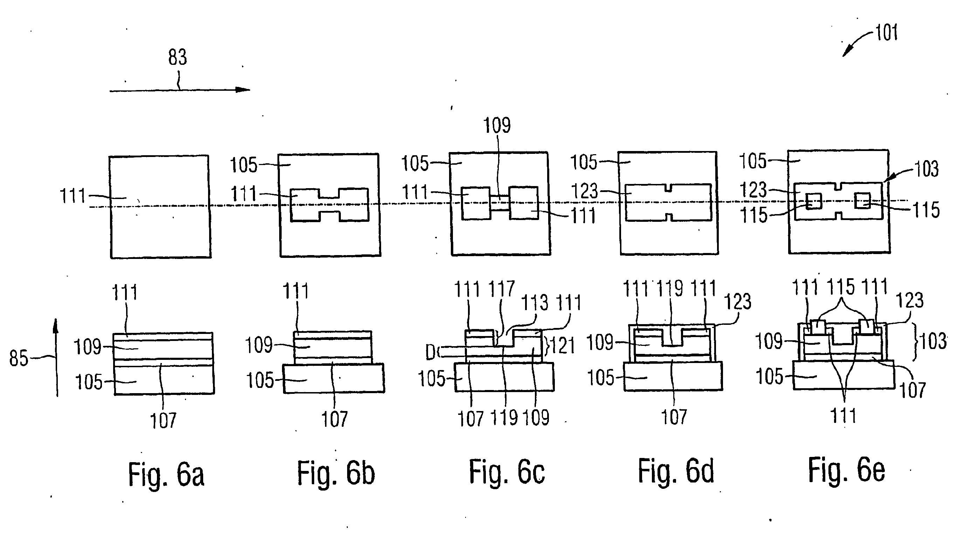

In Figur 3 und Figur 4 wurden jeweils eine Verengung 65 entlang der lateralen Ausdehnung 45 gebildet. Darüber hinaus, könnte auch eine Verengung der Speichermaterialschicht 49 entlang der vertikalen Ausdehnung 43 erfolgen, was in den Figuren 3 und 4 nicht gezeigt ist, aber anhand der Figur 6 erläutert wird.

In der lateralen Ausdehnung 45 wird die Strukturgröße durch die Lithographiegröße F bestimmt, die bei derzeitiger Technologie jedenfalls in einem Bereich von etwa 45nm bis 130nm liegt, mit zukünftiger Technologie wohl auch unterhalb von 45nm. In der vertikalen Ausdehnung lässt sich der Schaltbereich bei dem hier vorliegenden lateralen Konzept eines Phasenwechselspeichers 41, 71 darüberhinaus bis auf eine Dicke D weit unterhalb von 5nm bis hin zu einer atomaren Schichtdicke von 0,5nm prozessieren. Die über die Größen F x D senkrecht zur lateralen Ausdehnung 45 gebildete Durchtrittsfläche der Stromführung 63, 77 im Schaltbereich 61 ist bei dem vorliegenden lateralen Konzept und Aufbau eines Phasenwechselspeichers 41, 71 wesentlich geringer als die durch F² kleinst mögliche Durchtrittsfläche der Stromführung bei einem Phasenwechselspeicher im üblichen vertikalen Aufbau. Je nach Bedarf lässt sich bei der hier erläuterten ersten und zweiten bevorzugten Ausführungsform der Figuren 3 und 4 ein Verhältnis der Durchtrittsfläche der Stromführung 63, 77 im Schaltbereich 61 zu einer Durchtrittsfläche der Stromführung am ersten elektrischen Kontakt 47, 73 oder zweiten elektrischen Kontakt 51, 75 verengen, wobei das Verhältnis der Durchtrittsflächen vorzugsweise zwischen 1:2 und 1:100 liegt.

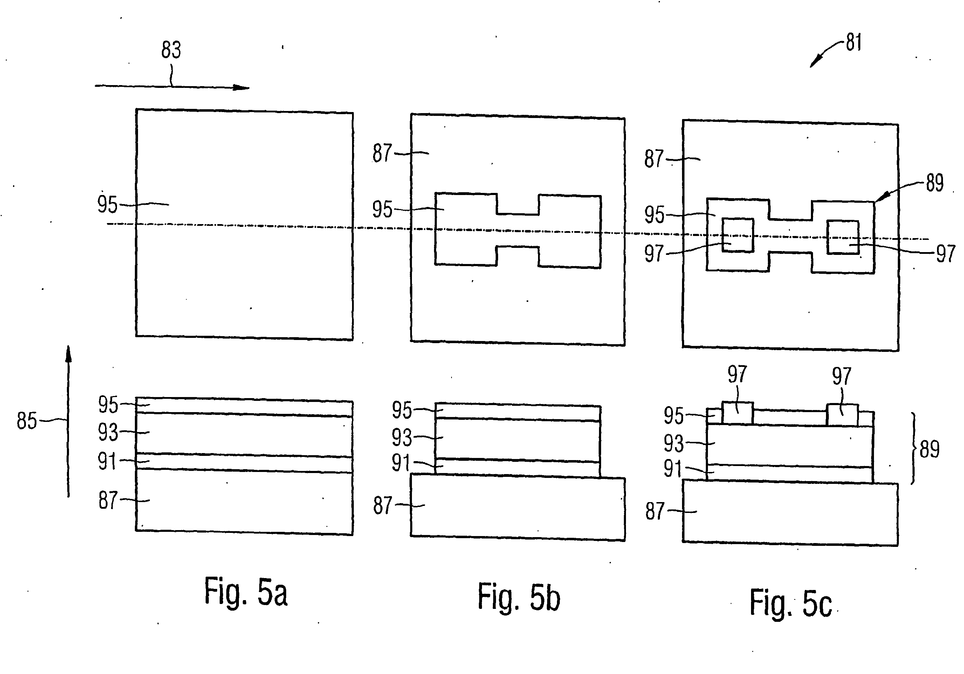

Figur 5 zeigt eine erste schematisiert dargestellte Prozessierfolge in drei Schritten (a), (b) und (c) für eine weitere bevorzugte Ausführungsform eines vorgeschlagenen Phasenwechselspeichers 81. Die oberen Darstellungen zeigen jeweils eine Draufsicht entlang der lateralen Ausdehnung 83. Die unteren Darstellungen zeigen jeweils eine Schnittansicht entlang der vertikalen Ausdehnung 85. Ausgangsmaterial für diese grundlegende Prozessierfolge ist ein Siliziumsubstrat 87, auf dem ein Schichtsystem als MESA-Struktur 89 mit den einzelnen Schichten in der Lithographie/Depositionsebene entlang der lateralen Ausdehnung 83 deponiert werden. Das Substrat 87 dient bei dieser Ausführungsform gleichzeitig als Wärmesenke. Auf dem Substrat 87 wird zunächst ein Isolator als Wärmeleitungsschicht 91 und Isolation aufgebracht. Bei dieser Ausführungsform ist dies eine ZnS:SiO₂-Schicht, wobei das Verhältnis von ZnS zu SiO₂70:30 beträgt. Danach wird ein Phasenwechselmaterial als eine Speichermaterialschicht 93 aufgebracht. Bei dieser Ausführungsform ist das Phasenwechselmaterial ein [Sn]:GeSbTe-basiertes Material. Schließlich wird eine Passivierµungsschicht 95, hier aus SiO₂, aufgebracht. Im Schritt (b) wird über einen geeigneten Litographie- und Ätzprozess eine MESA-Struktur definiert und strukturiert. Im Schritt (c) werden über einen Lithographie-und Ätzprozess Kontaktfenstem in der Passivierungsschicht 95 geöffnet und über einen Lift-Off-Prozess mit elektrischen Kontakten 97 metallisiert.

Figur 6 zeigt eine zweite schematisiert dargestellte Prozessierfolge in fünf Schritten (a), (b), (c), (d) und (e) noch einer weiteren bevorzugten Ausführungsform des vorgeschlagenen Phasenwechselspeichers 101. Dieser ist wiederum über eine MESA-Struktur 103 realisiert. Die oberen Darstellungen zeigen jeweils eine Draufsicht entlang der lateralen Ausdehnung 83. Die unteren Darstellungen zeigen jeweils eine Schnittansicht entlang der vertikalen Ausdehnung 85.

Die vorliegende bevorzugte Ausführungsform des Phasenwechselspeichers 101 hat den Vorteil eines verringerten Bahnwiderstands und einer Zellenpassivierung. Der verringerte Bahnwiderstand hat eine geringere Betriebsspannung zur Folge und die Zellenpassivierung verhindert eine Eindiffusion von umgebendem Luftsauerstoff. Ausgangspunkt bei der weiteren bevorzugten Ausführungsform der Figur 6 ist ein im Bild (a) dargestelltes modifiziertes Schichtsystem aus einem Substrat 105, einer Wärmeleitungsschicht 107, einer Speichermaterialschicht 109 und nunmehr einer elektrisch leitenden Schicht 111 als oberster Schicht.

Über einen geeigneten Lithographie- und Ätzprozess (b) wird zunächst eine MESA-Struktur definiert und strukturiert. Ein weiterer Lithographie- und Ätzprozess (c) definiert und strukturiert einen Graben 113 in der Region des Schaltbereichs. Der Graben 113 trennt einerseits die oberste elektrisch leitende Schicht 111 auf und definiert somit eine Position der elektrischen Kontakte 115 vor. Andererseits wird durch Einstellen der Ätztiefe 117 die Dicke D des Schaltbereichs 119 eingestellt. Damit wird auch der Stromverbrauch des Phasenwechselspeichers 101 eingestellt. Bei dieser weiteren Ausführungsform des Phasenwechselspeichers 101 der Figur 6 ist also die Dicke D der Speichermaterialschicht 109, als Abmessung einer Verengung in der vertikalen Ausdehnung 85, geringer als eine Abmessung 121 der Speichermaterialschicht 109 in der vertikalen Ausdehnung 85 an der Kontaktierung, bestehend aus den elektrischen Kontakten 115 und der aufgetrennten elektrisch leitenden Schicht 111.

Mit Hilfe eines geeigneten Depositionsprozesses (d) wird die bestehenden Schichtfolge mit einer Passivierung 123 versehen. In einem weiteren Schritt (e) werden über einen Lithographie-und Ätzschritt Kontaktfenster in die deponierte Passivierung 123 strukturiert und wiederum mit Hilfe eines Lift-Off-Prozesses mit elektrischen Kontakten 115 metallisiert.

Figur 7 zeigt eine bevorzugte Ausführungsform einer Phasenwechselspeicheranordnung 131, die einen ersten Phasenwechselspeicher 133 einen zweiten Phasenwechselspeicher 135 und einen dritten Phasenwechselspeicher 137 miteinander verknüpft. Dabei ist von jedem Phasenwechselspeicher 133, 135, 137 jeweils einer der elektrischen Kontakte 139, 141, 143 zusammen mit den anderen der jeweils einen elektrischen Kontakte 139, 141, 143 zusammen auf gleichem elektrischen Potential gelegt, indem die elektrischen Kontakte 139, 141 und 143 auf ein allen gemeinsames Pad 145 geführt sind, das auf Masse 147 gelegt ist. Den jeweils anderen elektrischen Kontakten 149, 151, 153 ist ein jeweils schaltbares festes Potenzial über ein weiteres jeweils zugeordnetes Pad 155, 157, 159 zugeordnet.

Diese Ausführungsform einer Phasenwechselspeicheranordnung 131 ist lediglich als ein Beispiel von vielen je nach Bedarf ausführbaren Ausführungsformen einer Phasenwechselspeicheranordnung zu verstehen.

Der Aufbau einer Phasenwechselspeicherzelle aus einem Phasenwechselspeicher oder einer Phasenwechselspeicheranordnung erfolgt gemäß der in den Figuren 8 und 9 schematisiert dargestellten Ausführungsformen im Rahmen einer CMOS-Integration von Phasenwechseispeicherzellen im lateralen Aufbau und Konzept.

Eine besonders bevorzugte Ausführungsform einer Integration eines Phasenwechselspeichers 161 erfolgt, wie in Figur 8 gezeigt, über einen ersten elektrischen Kontakt 163 auf einem CMOS-Steuertransistor 165. Das entsprechende Ersatzschaltbild ist auf der rechten Seite der Figur 8 gezeigt. Die Phasenwechselspeicherzelle 167 der Figur 8 ist auf einem Siliziumsubstrat 169 prozessiert und im übrigen mit einer Passivierung 171 versehen. Der Steuertransistor 165 definiert bei dieser Ausführungsform über Source oder Drain eine Bit-Line BL, über sein Gate eine Word-Line WL und über Source oder Drain einen Schaltkontakt 173 zur metallischen Kontaktierung 163.

Der Phasenwechselspeicher 161 ist mit einer Passivierung 171 versehen und weist einen zwischen dem ersten elektrischen Kontakt 163 und dem zweiten elektrischen Kontakt 175 beabstandet angeordneten Schaltbereich 177 in einer Speichermaterialschicht 179 auf. Bei der in Figur 8 gezeigten Ausführungsform des Phasenwechselspeichers 161 befindet sich eine Wärmesenke 181 als Metallschicht über der Speichermaterialschicht 179, wobei die Speichermaterialschicht 179 und die Wärmesenke 181 über eine Isolationsschicht 183 zur thermischen und elektrischen Isolation von der Speichermaterialschicht 179 isoliert ist. Die als ganzflächige Metallsierung ausgebildete Wärmesenke 181 bildet bei der hier vorliegenden Ausführungsform eines Phasenwechselspeichers 161 auch den Masseanschluss 185.

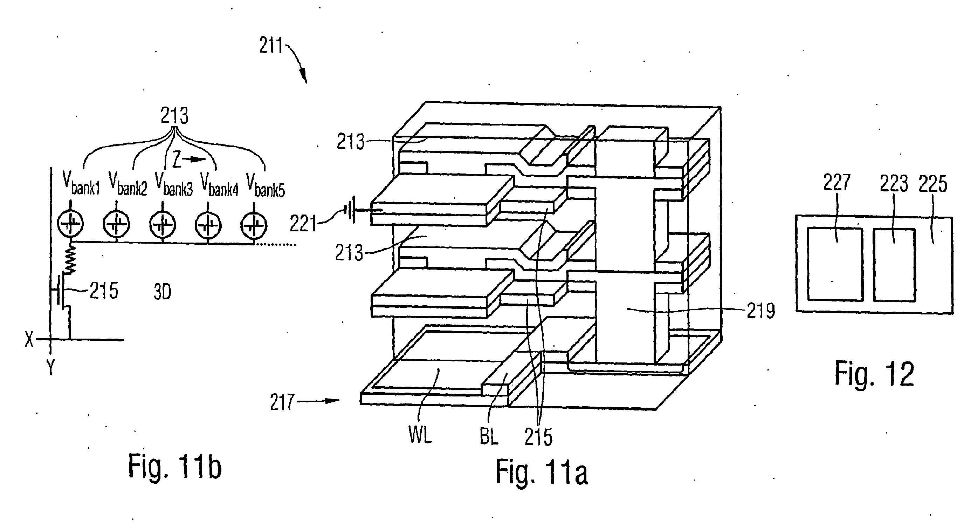

Figur 9 zeigt eine im Vergleich zur Figur 8 modifizierte bevorzugte Ausführungsform einer Phasenwechselspeicherzelle 187. Funktionsgleiche Elemente der Phasenwechselspeicherzelle 187 der Figur 9 und der Phasenwechselspeicherzelle 167 der Figur 8 wurden mit gleichen Bezugszeichen versehen. Bei der Ausführungsform der Phasenwechselspeicherzelle 187 ist im Unterschied zu der Ausführungsform einer Phasenwechselspeicherzelle 167 nicht ein Transistor 165 als Selektionseinheit mit nicht-linearer Stromspannungskennlinie zur Ansteuerung vor den Phasenwechselspeicher 162 geschaltet, sondern eine Diode 191. Dabei kann der obere, zweite elektrische Kontakt 175 als Word-Line und der untere, erste elektrische Kontakt 163 als Bit-Line (oder umgekehrt) direkt für eine anhand der Figuren 10 und 11 erläuterte X/Y Adressierung genutzt werden.

Die Diode 191 ist weiters im Phasenwechselspeicher 162 integriert. Bei der Phasenwechselspeicherzelle 167 der Figur 8 war der Transistor 165 als Selektionseinheit extern vor den Phasenwechselspeicher 161 geschaltet. Vorliegend ist bei der Phasenwechselspeicherzelle 187 der Figur 9 die Diode 191 zwischen der Speichermaterialschicht 179 und dem ersten elektrischen Kontakt 163 des Phasenwechselspeichers 162 angeordnet.

In einer Abwandlung dieser Ausführungsform könnte eine beliebige Selektionseinheit auch zwischen der Speichermaterialschicht 179 und dem zweiten elektrischen Kontakt 175 angeordnet sein.

Die Integration einer Selektionseinheit, vorliegend einer Diode 191, hat den Vorteil, dass dies die Prozessierung einer Phasenwechselspeicherzelle 187 erheblich vereinfacht und zudem aufgrund des verringerten Raumbedarfs die Integrationsdichte für eine Phasenwechselspeicherzelle 187 erheblich erhöht.

Für zukünftige Speicherkonzepte wird der Kostenfaktor "bit per area ratio" eine dominante Rolle spielen. Überlegungen, die eigentlichen Phasenwechselspeicherzellen übereinander zu "stapeln" und damit dreidimensionale 3D-Phasenwechselspeicher-Zellen-Arrays zu bilden sind in diesem Zusammenhang sehr reizvoll. Vorliegend bietet der laterale Aufbau und das laterale Konzept eines hier erläuterten Phasenwechselspeichers einen für diese Art der Integration entscheidenden Vorteil gegenüber dem vertikalen Aufbau eines üblichen Phasenwechselspeichers.

Der Aufbau eines 3D-Phasenwechselspeicher-Zellen-Arrays erfolgt mit einer Anzahl von übereinander angeordneten Speicherschichten in Form von 2D-Phasenwechselspeicher-Zellen-Arrays. Ein 2D-Phasenwechselspeicher-Zellen-Array 201 ist in Figur 10 im Detail (a) und als Ersatzschaltbild (b) gezeigt. Das 2D-Phasenwechselspeicher-Zellen-Array 201 umfasst eine Anzahl von zweidimensional im Rahmen einer Zeilen/Spalten (x/y)-Adressierung verschalteten und einzeln adressierbaren Phasenwechselspeicherzellen 203. Jede der Phasenwechselspeicherzellen 203 ist vorliegend jeweils aus einem Transistor 205 und einem Phasenwechselspeicher 207 aufgebaut. Bevorzugt wird anstatt eines Transistors eine Diode verwendet. Ein in Figur 11 gezeigtes 3D-Phasenwechselspeicher-Zellen-Array 211 ist in seinem dreidimensionalen Aufbau (a) und als Ersatzschaltbild (b) gezeigt. Es weist eine Anzahl von übereinander angeordneten 2D-Phasenwechselspeicher-Zellen-Arrays 213 auf. Dabei sind jeweils direkt übereinander angeordnete Phasenwechselspeicher 215 von einem Auswahltransistor 217 über ein gemeinsames Via 219 angesteuert und kontaktiert. Eine solche Integration ist bei einem Phasenwechselspeicher im vertikalen Aufbau nur bedingt möglich und bisher nicht realisiert, da ein gemeinsames Via nicht oder nur unter zusätzlichem Platzaufwand realisiert werden kann. Vielmehr ist, wie in der US 6,525,953 B1 beschrieben, ein übliches 3D-Phasenwechselspeicher-Zellen-Array auf die separate Kontaktierung jedes einzelnen Zeilen- und Spaltenkontaktes (entsprechend als Word- oder Bit-Line oder umgekehrt) bei allen Speicherschichten angewiesen.

Dagegen erfolgt bei der vorliegenden Ausführungsform eines 3D-Phasenwechselspeicherzellen-Arrays 211 der Figur 11 die Schaltung von jeweils direkt übereinander angeordneten Phasenwechselspeichem 215 über das gemeinsame Via 219 auf ein erstes festes Potential. Auf diese Weise erfolgt die Zeilen/Spalten (x/y) Adressierung für die Ebenen. Alle übereinander liegenden Phasenwechselspeicher 215 entlang einer Z-Richtung liegen somit auf dem durch das Via 219 vorgegebenen festen ersten Potenzial. Die Z-Adressierung, beispielsweise die Auswahl der unteren Phasenwechselspeicherzelle 215 in der Ausführungsform 211 der Figur 11, erfolgt bei dieser Ausführungsform indem alle anderen Phasenwechselspeicherzellen der weiteren 2D-Phasenwechselspeicherzellen-Arrays auf ein zweites, freies,
z. B. Massepotenzial 221 gelegt werden.

Figur 12 zeigt einen Elektronikbaustein 225 (Embeded Device , z.B. ASICS), der eine integrierte Speicher- 227 und/oder Logikfunktion 223 vereinigt. Dabei weist die integrierte Speicher- 227 und/oder Logikfunktion 223 einen Phasenwechselspeicher, eine Phasenwechselspeicheranordnung, eine Phasenwechselspeicherzelle oder ein Phasenwechselspeicher-Zellen-Array der oben beschriebenen Art auf.

Zusammenfassend ist die Stromflussbegrenzung zum Schalten eines Phasenwechselspeichers (PC-RAM) ein wesentliches Problem bei Phasenwechselspeichem bekannter Art. Dabei basieren alle bisherigen Konzepte zur Realisierung eines Phasenwechselspeichers auf einer vertikalen Stromführung, die senkrecht zur lateralen Ausdehnung des Phasenwechselspeichers zwischen zwei übereinander liegenden elektrischen Kontakten erfolgt. Bekannte Phasenwechselspeicher sind also für eine zur Lithographie/Depositionsebene vertikale Stromführung ausgelegt.

Eine besonders effiziente Strombegrenzung wird erreicht bei einem Phasenwechselspeicher 21, 41, 71, 81, 101, 161, 162, 215 mit einer Speichermaterialschicht 23, 49, 93, 109, 179 eines Phasenwechselmaterials, und einem ersten 25, 47, 73, 97, 115 und zweiten 27, 51, 75, 97, 115 elektrischen Kontakt, die von einander beabstandet sind und über die ein Schaltbereich 31, 61, 119, 177 der Speichermaterialschicht 23, 49, 93, 109, 179 von einem Stromsignal durchsetzbar ist, wobei mittels dem Stromsignal ein Phasenwechsel 11, 13 zwischen einer kristallinen Phase 3 und einer amorphen Phase 5 und damit eine Widerstandsänderung 7 des Phasenwechselmaterials im Schaltbereich 31, 61, 119, 177 induzierbar ist. Bei einem solchen Phasenwechselspeicher ist im Rahmen des neuen Konzepts vorgesehen, dass der Schaltbereich 31, 61, 119, 177 entlang einer lateralen Ausdehnung 33, 45, 83 des Phasenwechselspeichers zwischen dem ersten 25, 47, 73, 97, 115 und zweiten 27, 51, 75, 97, 115 elektrischen Kontakt angeordnet ist, wobei eine Stromführung 35, 63, 77 des Stromsignals durch den Schaltbereich 31, 61, 119, 177 entlang der lateralen Ausdehnung 33, 45, 83 erfolgt. Unter anderem lässt sich auf diese Weise eine senkrecht zur lateralen Ausdehnung gebildete Durchtrittsfläche der Stromführung 35, 63, 77 erheblich verringern, so dass der für ein Stromsignal benötigte Schaltstrom erheblich verringert ist.
Das neue Konzept führt auch auf eine Phasenwechselspeicheranordnung 131, eine Phasenwechselspeicherzelle 167, 187, 203, ein 2D-Phasenwechselspeicherzellen-Array 201, 213, ein 3D-Phasenwechselspeicherzellen-Array 211 und einen Elektronikbaustein 225.

### Bezugszeichenliste

- 1: Widerstands-Temperatur-Grafik
- 3: kristalline Phase
- 5: amorphe Phase
- 7: Widerstandsänderung
- 9: Temperaturänderung
- 11: Amorphisierung
- 13: Kristallisation
- 21: Phasenwechselspeicher
- 23: Speichermaterialschicht
- 25: erster elektrischer Kontakt
- 27: zweiter elektrischer Kontakt
- 29: Abstand
- 31: Schaltbereich
- 33: laterale Ausdehnung
- 35: Stromführung
- 41: erste bevorzugte Ausführungsform eines Phasenwechselspeichers
- 43: vertikale Ausdehnung
- 45: laterale Ausdehnung
- 47: erster elektrischer Kontakt
- 49: Speichermaterialschicht
- 51: zweiter elektrischer Kontakt
- 53: Passivierung
- 55: Keimbildungsbereich
- 57: ZnS:SiO₂ Schicht
- 59: Silizium-Wärme-Senke
- 61: Schaltbereich
- 63: Stromführung
- 65: Verengung
- 67: Abmessung
- 69: Abmessung
- 71: zweite bevorzugte Ausführungsform eines Phasenwechselspeichers
- 73: erster elektrischer Kontakt
- 75: zweiter elektrischer Kontakt
- 77: modifizierte Stromführung
- 79: thermischer Abstand
- 81: weitere bevorzugte Ausführungsform eines Phasenwechselspeichers Phasenwechselspeicher
- 83: laterale Ausdehnung
- 85: vertikale Ausdehnung
- 87: Siliziumsubstrat
- 89: MESA-Struktur
- 91: Wärmeleitungsschicht
- 93: Speichermaterialschicht
- 95: Passivierungsschicht
- 97: elektrische Kontakte
- 101: Phasenwechselspeicher
- 103: MESA-Struktur
- 105: Substrat
- 107: Wärmeleitungsschicht
- 109: Speichermaterialschicht
- 111: elektrisch leitende Schicht
- 113: Graben
- 115: elektrische Kontakte
- 117: Ätztiefe
- 119: Schaltbereich
- 123: Passivierung
- 131: Phasenwechselspeicheranordnung
- 133: erster Phasenwechselspeicher
- 135: zweiter Phasenwechselspeicher
- 137: dritter Phasenwechselspeicher
- 139,141,143: elektrischer Kontakt
- 145: Pad
- 147: Masse
- 149, 151, 153: elektrischer Kontakt
- 155, 157, 159: Pad
- 161: Phasenwechselspeicher
- 162: Phasenwechselspeicher
- 163: erster elektrischer Kontakt
- 165: CMOS-Steuertransistor
- 167: Phasenwechselspeicherzelle
- 169: Silizumsubstrat
- 171: Passivierung
- 173: Schaltkontakt
- 175: zweiter elektrischer Kontakt
- 177: Schaltbereich
- 179: Speichermaterialschicht
- 181: Wärmesenke
- 183: Isolationsschicht
- 185: Masseanschluss
- 187: Phasenwechselspeicherzelle
- 191: Diode
- 201: 2D-Phasenwechselspeicher-Zellen-Array
- 203: adressierbare Phasenwechselspeicherzellen
- 205: Transistor
- 207: Phasenwechselspeicher
- 211: 3D-Phasenwechselspeicher-Zellen-Array
- 213: 2D-Phasenwechselspeicher-Zellen-Array
- 215: Phasenwechselspeicher
- 217: Auswahltransistor
- 219: Via
- 221: Massepotenzial
- 223: Speicher- und/oder Logikfunktion
- 225: Elektronikbaustein
- 227: anwendungsbezogener Baustein (Embeded Device)

- D: Dicke

## Patentansprüche

1. Phasenwechselspeicher (21, 41, 71, 81, 101, 161, 162, 215) mit einer Speichermaterialschicht (23, 49, 93, 109, 179) eines Phasenwechselmaterials, und einem ersten (25, 47, 73, 97, 115) und zweiten (27, 51, 75, 97, 115) elektrischen Kontakt, die von einander beabstandet sind und über die ein Schaltbereich (31, 61, 119, 177) der Speichermaterialschicht (23, 49, 93, 109, 179) von einem Stromsignal durchsetzbar ist, wobei mittels dem Stromsignal ein reversibler Phasenwechsel (11, 13) zwischen einer kristallinen Phase (3) und einer amorphen Phase (5) und damit eine Widerstandsänderung (7) des Phasenwechselmaterials im Schaltbereich (31, 61, 119, 177) induzierbar ist,
**dadurch gekennzeichnet,**
**dass** der Schaltbereich (31, 61, 119,177) entlang einer lateralen Ausdehnung (33, 45, 83) des Phasenwechselspeichers parallel zur Lithographieebene/Depositionsebene des Phasenwechselspeichers zwischen dem ersten (25, 47, 73, 97, 115) und zweiten (27, 51, 75, 97, 115) elektrischen Kontakt angeordnet ist, wobei eine. Stromführung (35, 63, 77) des Stromsignals durch den Schaltbereich (31, 61, 119, 177) entlang der lateralen Ausdehnung (33, 45, 83) parallel zur Lithographieebene/Depositionsebene erfolgt, und wobei der Schaltbereich (31, 61, 119, 177) bei einer Verengung (65) zwischen dem ersten (25, 47, 73, 97, 115) und zweiten (27, 51, 75, 97, 115) elektrischen Kontakt in der Speichermaterialschicht (23, 49, 93, 109, 179) angeordnet ist, wobei eine Abmessung (67, D) der Verengung (65) geringer ist, als eine Abmessung (69, 121) der Speichermaterialschicht (23, 49, 93, 109, 179) am ersten (25, 47, 73, 97, 115) oder zweiten (27, 51, 75, 97, 115) elektrischen Kontakt, und wobei die Speichermaterialsicht (23, 49,93,109,179) über eine thermische Barriere (57, 91, 107, 183) in Form einer auf ZnS- SiO₂-basierenden Schicht von einer Wärmesenke (59, 87, 105, 181) isoliert ist.

2. Phasenwechselspeicher (21,41, 71, 81, 101, 161, 162, 215) nach Anspruch 1,
**dadurch gekennzeichnet,**
**dass** eine senkrecht zur lateralen Ausdehnung parallel zur Lithographieebene/Depositionsebene gebildete Durchtrittsfläche der Stromführung (35, 63, 77) im Schaltbereich (31, 61, 119, 177) im Verhältnis zu einer Durchtrittsfläche der Stromführung (35, 63, 77) am ersten (25, 47, 73, 97, 115) oder zweiten (27, 51, 75, 97, 115) elektrischen Kontakt verengt ist, wobei das Verhältnis der Duchtrittsflächen zwischen 1:2 und 1:100 liegt.

3. Phasenwechselspeicher (41, 71) nach Anspruch 1 oder 2,
**dadurch gekennzeichnet,**
**dass** eine Abmessung (67) der Verengung (65) in der lateralen Ausdehnung (45) parallel zur Lithographieebene/Depositionsebene geringer ist, als eine Abmessung (69) der Speichermaterialschicht (49) in der lateralen Ausdehnung (45) parallel zur Lithographieebene/Depositionsebene am ersten (47, 73) oder zweiten (51, 75) elektrischen Kontakt.

4. Phasenwechselspeicher (101) nach einem der Ansprüche 1 bis 3,
**dadurch gekennzeichnet,**
**dass** eine Abmessung (D) der Verengung in der vertikalen Ausdehnung (85) senkrecht zur Lithographieebene/Depositionsebene geringer ist, als eine Abmessung (121) der Speichermaterialschicht (109) in der vertikalen Ausdehnung (85) senkrecht zur Lithographieebene/Depositionsebene am ersten oder zweiten elektrischen Kontakt (115).

5. Phasenwechselspeicher (21, 41,71, 81, 101, 161, 162, 215) nach einem der Ansprüche 1 bis 4,
**dadurch gekennzeichnet,**
**dass** der erste (25, 47, 73, 97, 115) und/oder der zweite (27, 51, 75, 97, 115) elektrische Kontakt unmittelbar an die Speichermaterialschicht (23, 49, 93, 109, 179) grenzen und der Schaltbereich (31, 61, 119, 177) beabstandet (79) vom ersten (25, 47, 73, 97, 115) und/oder zweiten (27, 51, 75, 97, 115) Kontakt in der Speichermaterialschicht (23, 49, 93, 109, 179) gebildet ist.

6. Phasenwechselspeicher (41,161,162,215) nach einem der Ansprüche 1 bis 5,
**dadurch gekennzeichnet,**
**dass** der Abstand zwischen dem ersten (47, 163) und zweiten (51, 175) elektrischen Kontakt entlang der lateralen Ausdehnung (45) parallel zur Lithographieebene/Depositionsebene ausgerichtet ist, wobei der erste elektrische Kontakt (47, 163) unterhalb der Speichermaterialschicht (49, 179) angeordnet ist und der zweite elektrische Kontakt (51, 175) oberhalb der Speichermaterialschicht (49, 179) angeordnet ist.

7. Phasenwechselspeicher (71, 81, 101) nach einem der Ansprüche 1 bis 6,
**dadurch gekennzeichnet,**
**dass** der Abstand zwischen dem ersten (73, 97, 115) und zweiten (75, 97, 115) elektrischen Kontakt entlang der lateralen Ausdehnung (83) parallel zur Lithographieebene/Depositionsebene ausgerichtet ist, wobei der erste (73, 97, 115) und der zweite (75, 97, 115) elektrische Kontakt oberhalb der Speichermaterialschicht (93, 109) angeordnet sind.

8. Phasenwechselspeicher (21, 41, 71, 81, 101, 161,162, 215) nach Anspruch 6 oder 7,
**dadurch gekennzeichnet,**
**dass** der Schaltbereich (31, 61, 119, 177) in einer Region zwischen dem ersten (25, 47, 73, 97, 115) und zweiten (27, 51, 75, 97, 115) elektrischen Kontakt und unterhalb des ersten (25, 47, 73, 97, 115) und oberhalb des zweiten (27, 51, 75, 97, 115) bzw. oberhalb des ersten (25, 47, 73, 97, 115) und unterhalb des zweiten (27, 51, 75, 97, 115) elektrischen Kontakts entlang der lateralen Ausdehnung (33, 45, 83) parallel zur Lithographieebene/Depositionsebene angeordnet ist.

9. Phasenwechselspeicher (41, 71) nach einem der Ansprüche 1 bis 8,
**dadurch gekennzeichnet,**
**dass** unmittelbar an die Speichermaterialschicht (49) ein Keimbildungsbereich (55) grenzt.

10. Phasenwechselspeicher (21, 41, 71, 81, 101, 161, 162, 215) nach einem der Ansprüchen 1 bis 9,
**dadurch gekennzeichnet,**
**dass** der erste(25, 47, 73, 97, 115) und zweite (27, 51, 75, 97, 115) elektrische Kontakt und die Speichermaterialschicht (23, 49, 93, 109, 179) Teil einer auf einem Substrat (87, 105, 169) aufgebrachten MESA-Struktur (89, 103) sind.

11. Phasenwechselspeicheranordnung (131) mit einem oder mehreren Phasenwechselspeichem (21,41,71,81,101,161,162,215) nach einem der Ansprüchen 1 bis 10,
**dadurch gekennzeichnet,**
**dass** von jedem Phasenwechselspeicher (133, 135, 137) jeweils einer der elektrischen Kontakte (139, 141, 143) mit den anderen der jeweils einen elektrischen Kontakte (139, 141, 143) zusammen auf gleichem elektrischen Potenzial (147) liegt.

12. Phasenwechselspeicherzelle (167, 187, 203) mit einem Phasenwechselspeicher (21, 41, 71, 81, 101, 161, 162, 215) nach einem der Ansprüche 1 bis 10 und/oder einer Phasenwechselspeicheranordnung (131) nach Anspruch 11
**gekennzeichnet durch**
eine Selektionseinheit (165, 191) mit nicht-linearer Strom-Spannungs-Kennlinie.

13. Phasenwechselspeicherzelle (167, 187, 203) nach Anspruch 12,
**dadurch gekennzeichnet,**
**dass** die Selektionseinheit (165, 191) im Phasenwechselspeicher (162) und/oder der Phasenwechselspeicheranordnung integriert ist.

14. Phasenwechselspeicherzelle(167, 187, 203) nach Anspruch 13,
**dadurch gekennzeichnet,**
**dass** die Selektionseinheit (165, 191) zwischen der Speichermaterialschicht (179) und dem ersten elektrischen Kontakt (163) und/oder zwischen der Speichermaterialschicht (179) und dem zweiten elektrischen Kontakt (175) im Phasenwechselspeicher (162) angeordnet ist.

15. 2D-Phasenwechselspeicher-Zellen-Array (201, 213)
**gekennzeichnet durch**
eine Anzahl von zwei-dimensional verschalteten und einzeln adressierbaren Phasenwechselspeicherzellen ((167, 187, 203)) nach einem der Ansprüche 12 bis 14.

16. 3D-Phasenwechselspeicher-Zellen-Array (211) mit einer Anzahl von übereinander angeordneten 2D-Phasenwechlselspeicher-Zellen-Arrays (201, 213) nach Anspruch 15,
**dadurch gekennzeichnet,**
**dass** jeweils direkt übereinander angeordnete Phasenwechselspeicher (215) über ein gemeinsames Via (219) kontaktiert sind.

17. 3D-Phasenwechselspeicherzellen-Array (211) nach Anspruch 16,
**dadurch gekennzeichnet,**
**dass** zur Adressierung eines ausgewählten Phasenwechselspeichers (215) eines 2D-Phasenwechselspeicher-Zellen-Arrays (213) jeweils dazu direkt übereinander angeordnete Phasenwechselspeicher (215) über das gemeinsame Via (219) auf ein erstes Potenzial schaltbar sind und dabei alle weiteren Phasenwechselspeicherzellen eines jeden weiteren 2D-Phasenwechselspeicherzellen-Arrays (213) auf ein zweites Potenzial (221) schaltbar sind.

18. Elektronikbaustein (225) mit einem anwendungsbezogenen Baustein (227) und integrierter Speicher- und/oder Logik-Funktion (223), mit einem Phasenwechselspeicher (21, 41, 71, 81, 101, 161, 162, 215) nach einem der Ansprüche 1 bis 10 und/oder einer Phasenwechselspeicheranordnung (131) nach Anspruch 11 und/oder einer Phasenwechselspeicherzelle (167, 187, 203) nach einem der Ansprüche 12 bis 14 und/oder einem Phasenwechselspeicherzellen-Array (241, 213, 211) nach einem der Ansprüche 15 bis 17.

## Claims

1. Phase change memory (21, 41, 71, 81, 101, 161, 162, 215), comprising a memory material layer (23, 49, 93, 109, 179) of a phase change material and comprising a first (25, 47, 73, 97, 115) and a second (27, 51, 75, 97, 115) electrical contact which are at a distance from one another and by means of which a switching zone (31, 61, 119, 177) of the memory material layer (23, 49, 93, 109, 179) can be traversed by a current signal, it being possible by means of the current signal to induce a reversible phase change (11, 13) between a crystalline phase (3) and an amorphous phase (5) and thus a change in resistance (7) of the phase change material in the switching zone (31, 61, 119, 177), **characterised in that** the switching zone (31, 61, 119, 177) is arranged along a lateral extension (33, 45, 83) of the phase change memory parallel to the lithography plane/deposition plane of the phase change memory between the first (25, 47, 73, 97, 115) and the second (27, 51, 75, 97, 115) electrical contact, current conduction (35, 63, 77) of the current signal through the switching zone (31, 61, 119, 177) taking place along the lateral extension (33, 45, 83) parallel to the lithography plane/deposition plane, and the switching zone (31, 61, 119, 177) being arranged at a narrowed portion (65) between the first (25, 47, 73, 97, 115) and the second (27, 51, 75, 97, 115) electrical contact in the memory material layer (23, 49, 93, 109, 179), a dimension (67, D) of the narrowed portion (65) being less than a dimension (69, 121) of the memory material layer (23, 49, 93, 109, 179) at the first (25, 47, 73, 97, 115) or the second (27, 51, 75, 97, 115) electrical contact, and the memory material layer (23, 49, 93, 109, 179) being insulated from a heat sink (59, 87, 105, 181) via a thermal barrier (57, 91, 107, 183) in the form of a layer based on ZnS-SiO₂.

2. Phase change memory (21, 41, 71, 81, 101, 161, 162, 215) according to claim 1, **characterised in that** a traversed area, formed perpendicular to the lateral extension parallel to the lithography plane/deposition plane, for current conduction (35, 63, 77) in the switching zone (31, 61, 119, 177) is narrowed in relation to a traversed area for current conduction (35, 62, 77) at the first (25, 47, 73, 97, 115) or the second (27, 51, 75, 97, 115) electrical contact, the ratio of the traversed surface areas being between 1:2 and 1:100.

3. Phase change memory (47, 71) according to either claim 1 or claim 2, **characterised in that** a dimension (67) of the narrowed portion (65) in the lateral extension (45) parallel to the lithography plane/deposition plane is smaller than a dimension (69) of the memory material layer (49) in the lateral extension (45) parallel to the lithography plane/deposition plane at the first (47, 73) or the second (51, 75) electrical contact.

4. Phase change memory (101) according to any one of claims 1 to 3, **characterised in that** a dimension (D) of the narrowed portion in the vertical extension (85) perpendicular to the lithography plane/deposition plane is smaller than a dimension (121) of the memory material layer (109) in the vertical extension (85) perpendicular to the lithography plane/deposition plane at the first or the second electrical contact (115).

5. Phase change memory (21, 41, 71, 81, 101, 161, 162, 215) according to any one of claims 1 to 4, **characterised in that** the first (25, 47, 73, 97, 115) and/or the second (27, 51, 75, 97, 115) electrical contact are directly adjacent to the memory material layer (23, 49, 93, 109, 179), and the switching zone (31, 61, 119, 117) is formed at a distance (79) from the first (25, 47, 73, 97, 115) and/or the second (27, 51, 75, 97, 115) contact in the memory material layer (23, 49, 93, 109, 179).

6. Phase change memory (41, 161, 162, 215) according to any one of claims 1 to 5, **characterised in that** the distance between the first (47, 163) and the second (51, 175) electrical contact is directed along the lateral extension (45) parallel to the lithography plane/deposition plane, the first electrical contact (47, 163) being arranged below the memory material layer (49, 179) and the second electrical contact (51, 175) being arranged above the memory material layer (49, 179).

7. Phase change memory (71, 81, 101) according to any one of claims 1 to 6, **characterised in that** the distance between the first (73, 97, 115) and the second (75, 97, 115) electrical contact is directed along the lateral extension (83) parallel to the lithography plane/deposition plane, the first (73, 97, 115) and the second (75, 97, 115) electrical contact being arranged above the memory material layer (93, 109).

8. Phase change memory (21, 41, 71, 81, 101, 161, 162, 215) according to either claim 6 or claim 7, **characterised in that** the switching zone (31, 61, 119, 177) is arranged in a region between the first (25, 47, 73, 97, 115) and the second (27, 51, 75, 97, 115) electrical contact, and below the first (25, 47, 73, 97, 115) and above the second (27, 51, 75, 97, 115) electrical contact or above the first (25, 47, 73, 97, 115) and below the second (27, 51, 75, 97, 115) electrical contact, along the lateral extension (33, 45, 83) parallel to the lithography plane/deposition plane.

9. Phase change memory (41, 71) according to any one of claims 1 to 8, **characterised in that** there is a nucleation region (55) directly adjacent to the memory material layer (49).

10. Phase change memory (21, 41, 71, 81, 101, 161, 162, 215) according to any one of claims 1 to 9, **characterised in that** the first (25, 47, 73, 97, 115) and the second (27, 51, 75, 97, 115) electrical contact and the memory material layer (23, 49, 93, 109, 179) are part of a MESA structure (89, 103) which is applied to a substrate (87, 105, 169).

11. Phase change memory arrangement (131), comprising one or more phase change memories (21, 41, 71, 81, 101, 161, 162, 215) according to any one of claims 1 to 10, **characterised in that** a respective one of the electrical contacts (139, 141, 143) of each phase change memory (133, 135, 137) is at the same electrical potential (147) together with the other respective one electrical contacts (139, 141, 143).

12. Phase change memory cell (167, 187, 203), comprising a phase change memory (21, 41, 71, 81, 101, 161, 162, 215) according to any one of claims 1 to 10 and/or a phase change memory arrangement (131) according to claim 11, **characterised by** a selection unit (165, 191) having a non-linear current/voltage characteristic.

13. Phase change memory cell (167, 187, 203) according to claim 12, **characterised in that** the selection unit (165, 191) is integrated into the phase change memory (162) and/or the phase change memory arrangement.

14. Phase change memory cell (167, 187, 203) according to claim 13, **characterised in that** the selection unit (165, 191) is arranged between the memory material layer (179) and the first electrical contact (163) and/or between the memory material layer (179) and the second electrical contact (175) in the phase change memory (162).

15. 2D phase change memory cell array (201, 213), **characterised by** a number of two-dimensionally connected and individually addressable phase change memory cells (167, 187, 203) according to any one of claims 12 to 14.

16. 3D phase change memory cell array (211), comprising a number of 2D phase change memory arrays (201, 213) according to claim 15 arranged above one another, **characterised in that** the phase change memories (215) arranged directly above one another are contacted by way of a shared via (219).

17. 3D phase change memory cell array (211) according to claim 16, **characterised in that** to address a selected phase change memory (215) of a 2D phase change memory cell array (213), each of the phase change memories (215) arranged directly above one another for this purpose can be switched to a first potential by means of the shared via (219) and thus all of the other phase change memory cells of each of the other 2D phase change memory cell arrays (213) can be switched to a second potential (221).

18. Electronic module (225), comprising an application-specific module (227) and an integrated memory function and/or logic function (223), comprising a phase change memory (21, 41, 71, 81, 101, 161, 162, 215) according to any one of claims 1 to 10 and/or a phase change memory arrangement (131) according to claim 11 and/or a phase change memory cell (167, 187, 203) according to any one of claims 12 to 14 and/or a phase change memory cell array (201, 213, 211) according to any one of claims 15 to 17.

## Revendications

1. Mémoire à changement de phase (21, 41, 71, 81, 101, 161, 162, 215), avec une couche de matériau de mémoire (23, 49, 93, 109, 179) en un matériau à changement de phase, et un premier (25, 47, 73, 97, 115) et un deuxième (27, 51, 75, 97, 115) contact électrique, espacés l'un de l'autre et par l'intermédiaire desquels une zone de commutation (31, 61, 119, 177) de la couche de matériau de mémoire (23, 49, 93, 109, 179) est susceptible d'être traversée par un signal électrique, un changement de phase (11, 13) réversible étant susceptible d'être induit, au moyen du signal électrique, entre une phase cristalline (3) et une phase amorphe (5) et, ainsi, une variation de résistance (7) du matériau à changement de phase dans la zone de commutation (31, 61, 119, 177),
**caractérisée en ce que**
la zone de commutation (31, 61, 119, 177) est disposée le long d'une étendue latérale (33, 45, 83) de la mémoire à changement de phase, parallèlement au plan de lithographie/plan de déposition de la mémoire à changement de phase, entre le premier (25, 47, 73, 97, 115) et le deuxième (27, 51, 75, 97, 115) contact électrique, un guidage électrique (35, 63, 77) du signal électrique à travers la zone de commutation (31, 61, 119, 177) s'effectuant le long de l'étendue latérale (33, 45, 83), parallèlement au plan de lithographie/plan de déposition de la mémoire à changement de phase, et la zone de commutation (31, 61, 119, 177) étant disposée à un rétrécissement (65) dans la couche de matériau de mémoire (23, 49, 93, 109, 179), entre le premier (25, 47, 73, 97, 115) et le deuxième (27, 51, 75, 97, 115) contact électrique, une dimension (67, D) du rétrécissement (65) étant inférieure à une dimension (69, 121) de la couche de matériau de mémoire (23, 49, 93, 109, 179), au premier (25, 47, 73, 97, 115) ou au deuxième (27, 51, 75, 97, 115) contact électrique, et la couche de matériau de mémoire (23, 49, 93, 109, 179) étant isolée d'un dissipateur thermique (59, 87, 105, 181), par l'intermédiaire d'une barrière thermique (57, 91, 107, 183) se présentant sous la forme d'une couche à base de ZnS:SiO₂.

2. Mémoire à changement de phase (21, 41, 71, 81, 101, 161, 162, 215) selon la revendication 1,
**caractérisée en ce qu'**
une aire de passage, formée perpendiculairement à l'étendue latérale, parallèlement au plan de lithographie/plan de déposition, du guidage de courant (35, 63, 77), dans la zone de commutation (31, 61, 119, 177), est rétrécie par rapport à une aire de passage du guidage de courant (35, 63, 77) au niveau du premier (25, 47, 73, 97, 115) ou du deuxième (27, 51, 75, 97, 115) contact électrique, le rapport des aires de passage étant compris entre 1:2 et 1:100.

3. Mémoire à changement de phase (41, 71) selon la revendication 1 ou 2,
**caractérisée en ce qu'**
une dimension (67) du rétrécissement (65) dans l'étendue latérale (45), parallèlement au plan de lithographie/plan de déposition, est plus petite qu'une dimension (69) de la couche de matériau de mémoire (49) dans l'étendue latérale (45), parallèlement au plan de lithographie/plan de déposition, au niveau du premier (47, 73) ou du deuxième (51, 75) contact électrique.

4. Mémoire à changement de phase (101) selon l'une des revendications 1 à 3,
**caractérisée en ce qu'**
une dimension (D) du rétrécissement dans l'étendue verticale (85), perpendiculairement au plan de lithographie/plan de déposition, est plus petite qu'une dimension (121) de la couche de matériau de mémoire (109) dans l'étendue verticale (85), perpendiculairement au plan de lithographie/plan de déposition, au niveau du premier ou au niveau du deuxième (115) contact électrique.

5. Mémoire à changement de phase (21, 41, 71, 81, 101, 161, 162, 215) selon l'une des revendications 1 à 4,
**caractérisée en ce que**
le premier (25, 47, 73, 97, 115) et/ou le deuxième (27, 51, 75, 97, 115) contact électrique sont délimités directement au niveau de la couche de matériau de mémoire (23, 49, 93, 109, 179), et la zone de commutation (31, 61, 119, 177) est formée à distance (79) du premier (25, 47, 73, 97, 115) et/ou du deuxième (27, 51, 75, 97, 115) contact électrique, dans la couche de matériau de mémoire (23, 49, 93, 109, 179).

6. Mémoire à changement de phase (41, 161, 162, 215) selon l'une des revendications 1 à 5,
**caractérisée en ce que**
la distance, entre le premier (47, 163) et le deuxième (51, 175) contact électrique, est orientée le long de l'étendue latérale (45), parallèlement au plan de lithographie/plan de déposition, le premier contact électrique (47, 163) étant disposé au-dessous de la couche de matériau de mémoire (49, 179), et le deuxième contact électrique (51, 175) étant disposé au-dessus de la couche de matériau de mémoire (49, 179).

7. Mémoire à changement de phase (71, 81, 101) selon l'une des revendications 1 à 6,
**caractérisée en ce que**
la distance, entre le premier (73, 97, 115) et le deuxième (75, 97, 115) contact électrique, est orientée le long de l'étendue latérale (83), parallèlement au plan de lithographie/plan de déposition, le premier (73, 97, 115) et le deuxième (75, 97, 115) contact électrique étant disposés au-dessus de la couche de matériau de mémoire (93, 109).

8. Mémoire à changement de phase (21, 41, 71 81, 101, 161, 162, 215) selon la revendication 6 ou 7,
**caractérisée en ce que**
la zone de commutation (31, 61, 119, 177) est disposée dans une région située entre le premier (25, 47, 73, 97, 115) et le deuxième (27, 51, 75, 97, 115) contact électrique et au-dessous du premier (25, 47, 73, 97, 115) et au-dessus du deuxième (27, 51, 75, 97, 115), ou au-dessus du premier (25, 47, 73, 97, 115) et au-dessous du deuxième (27, 51, 75, 97, 115) contact électrique, le long de l'étendue latérale (33, 45, 83), parallèlement au plan de lithographie/plan de déposition.

9. Mémoire à changement de phase (41, 71) selon l'une des revendications 1 à 8,
**caractérisée en ce qu'**
une zone de formation de germes (55) est directement limitrophe à la couche de matériau de mémoire (49).

10. Mémoire à changement de phase (21, 41, 71, 81, 101, 161, 162, 215) selon l'une des revendications 1 à 9,
**caractérisée en ce que**
le premier (25, 47, 73, 97, 115) et le deuxième (27, 51, 75, 97, 115) contact électrique et la couche de matériau de mémoire (23, 49, 93, 109, 179) font partie d'une structure MESA (89, 103) appliquée sur un substrat (87, 105, 169).

11. Ensemble de mémoires à changement de phase (131), avec une ou plusieurs mémoires à changement de phase (21, 41, 71, 81, 101, 161, 162, 215) selon l'une des revendications 1 à 10,
**caractérisé en ce que**,
chaque fois l'un des contacts électriques (139, 141, 143) de chaque mémoire à changement de phase (133, 135, 137) est placé conjointement au même potentiel électrique (147) que l'autre des chaque fois un contact électrique (139, 141, 143).

12. Cellule de mémoire à changement de phase (167, 187, 203), avec une mémoire à changement de phase (21, 41, 71, 81, 101, 161, 162, 215) selon l'une des revendications 1 à 10 et/ou un ensemble de mémoires à changement de phase (131) selon la revendication 11,
**caractérisée par**
une unité de sélection (165, 191) à caractéristique intensité-tension non linéaire.

13. Cellule de mémoire à changement de phase (167, 187, 203) selon la revendication 12,
**caractérisée en ce que**
l'unité de sélection (165, 191) est intégrée dans la mémoire à changement de phase (162) et/ou l'ensemble de mémoires à changement de phase.

14. Cellule de mémoire à changement de phase (167, 187, 203) selon la revendication 13,
**caractérisée en ce que**
l'unité de sélection (165, 191) est disposée entre la couche de matériau de mémoire (179) et le premier contact électrique (163) et/ou entre la couche de matériau de mémoire (179) et le deuxième contact électrique (175) dans la mémoire à changement de phase (162).

15. Réseau de cellules de mémoire à changement de phase 2D (201, 213) selon la revendication 12,
**caractérisé par**
une pluralité de cellules de mémoire à changement de phase ((167, 187, 203)) branchées de manière bidimensionnelles et adressables individuellement, selon l'une des revendications 12 à 14.

16. Réseau de cellules de mémoire à changement de phase 3D (211) comprenant une pluralité de réseaux de cellules de mémoire à changement de phase 2D (201, 213) disposés les uns sur les autres, selon la revendication 15,
**caractérisé en ce que**
des mémoires à changement de phase (215), disposées chaque fois les unes au-dessus des autres, sont mises en contact par une traversée (219) commune.

17. Réseau de cellules de mémoire à changement de phase 3D (211) selon la revendication 16,
**caractérisé en ce que**,
pour l'adressage d'une mémoire à changement de phase (215) sélectionnée d'un réseau de cellules de mémoire à changement de phase 2D (213), des mémoires à changement de phase (215), disposées à cette fin chacune directement les unes au-dessus des autres, sont susceptibles d'être commutées à un premier potentiel, par l'intermédiaire de la traversée (219) commune, et toutes les autres cellules de mémoire à changement de phase d'un autre réseau de cellules de mémoire à changement de phase 3D (213) sont susceptibles d'être commutées à un deuxième potentiel (221).

18. Composant électronique (225) comprenant un composant (227) se référant à une application et une fonction mémoire et/ou logique (223) intégrée, avec une mémoire à changement de phase (21, 41, 71, 81, 101, 161, 162, 215) selon l'une des revendications 1 à 10 et/ou un ensemble de mémoires à changement de phase (131) selon la revendication 11 et/ou une cellule de mémoire à changement de phase (167, 187, 203) selon l'une des revendications 12 à 14 et/ou un réseau de cellules de mémoire à changement de phase (201, 213, 211) selon l'une des revendications 15 à 17.
